## Europäisches Patentamt
## European Patent Office
## Office européen des brevets

(19)

(11) Veröffentlichungsnummer: **0 396 710 B1**

(12) **EUROPÄISCHE PATENTSCHRIFT**

(45) Veröffentlichungstag der Patentschrift: **27.07.94**

(51) Int. Cl.5: **G01R 33/44**

(21) Anmeldenummer: **89912628.8**

(22) Anmeldetag: **13.11.89**

(86) Internationale Anmeldenummer:
**PCT/EP89/01360**

(87) Internationale Veröffentlichungsnummer:
**WO 90/06523 (14.06.90 90/14)**

(54) **VERFAHREN ZUM SELEKTIVEN ANREGEN VON NMR-SIGNALEN.**

(30) Priorität: **25.11.88 DE 3839820**

(43) Veröffentlichungstag der Anmeldung:
**14.11.90 Patentblatt 90/46**

(45) Bekanntmachung des Hinweises auf die
Patenterteilung:
**27.07.94 Patentblatt 94/30**

(84) Benannte Vertragsstaaten:
**CH DE FR GB LI**

(56) Entgegenhaltungen:
**US-A- 4 626 783**
**US-A- 4 710 715**
**US-A- 4 727 324**
**US-A- 4 748 409**
**US-A- 4 774 467**

**J. MAGN. RES., Band 77, 1988, Seiten 175-181**

**BIOCHEM. SOC. TRANS., Band 14, 1986, Seiten 1271-1272**

**J. MAGN. RES., Band 79, 1988, Seiten 561-567**

(73) Patentinhaber: **Spectrospin AG**
**Industriestrasse 26**
**CH-8117 Fällanden(CH)**

(72) Erfinder: **BODENHAUSEN, Geoffrey**
**11, chemin des Roches**
**CH-1009 Pully(CH)**
Erfinder: **EMSLEY, Lyndon**
**1, cheneau de Bourg**
**CH-1003 Lausanne(CH)**

(74) Vertreter: **KOHLER SCHMID + PARTNER**
**Patentanwälte**
**Ruppmannstrasse 27**
**D-70565 Stuttgart (DE)**

## Beschreibung

Die Erfindung betrifft ein Verfahren zum frequenzselektiven Anregen von NMR-Signalen mit selbständiger Refokussierung der Phasendispersion der durch die Anregung erzeugten transversalen Magnetisierung, bei welchem die Anregung durch Einstrahlen einer HF-Impulsfolge auf eine sich in einem homogenen statischen Magnetfeld befindende Probe erfolgt, welche HF-Impulsfolge wenigstens einen frequenz selektiven 270°-Impuls umfaßt. Ein solches Verfahren ist bekannt aus F. Loaiza et al., J. Magn. Reson. 77, 175 (1988).

Für viele Verfahren der NMR-Spektroskopie ist eine frequenzselektive Anregung der zu beobachtenden Kernspinresonanzen erforderlich. Ursprünglich wurden zur selektiven Anregung einfach zeitlich sehr lang andauernde HF-Rechteckimpulse geringer Leistung verwendet, die als "weiche" Impulse bezeichnet wurden. Die Anwendung solcher Impulse hat den Nachteil, daß ihr Frequenzspektrum Nebenzipfel aufweist, die von der Resonanzfrequenz weit entfernt sind und daher eine Anregung unerwünschter Kernspinresonanzen bewirken. Es hat sich gezeigt, daß ein sehr viel besseres Frequenzverhalten erzielt werden kann, wenn die Impulse keine rechteckige, sondern eine günstigere Form haben. Obwohl in den letzten Jahren Impulse mit ausgeklügelter Phasen- und Amplitudenmodulation entwickelt worden sind, hat sich wegen seiner relativ geringen zeitlichen Dauer und einfachen Form der Gauß-Impuls als besonders vorteilhaft erwiesen.

Der 90°-Gauß-Impuls hat jedoch wie alle anderen in der hochauflösenden NMR verwendeten Anregungsimpulse den Nachteil, daß er eine starke Phasendispersion in der resultierenden Transversal-Magnetisierung zur Folge hat. Bei der Aufnahme eindimensionaler Spektren wäre es zwar im Prinzip möglich, eine Phasenkorrektur erster Ordnung vorzunehmen, jedoch läßt sich eine solche Phasenkorrektur in der Praxis nicht durchführen, ohne starke Verschiebungen der Grundlinie des Spektrums in Kauf nehmen zu müssen. Bei komplizierteren Pulsexperimenten, bei denen eine Kohärenz-Übertragung stattfindet, ist eine solche Korrektur nicht mehr möglich, weil nicht nur gleichphasige, sondern auch gegenphasige Magnetisierungen auftreten.

Aus einem Aufsatz von Brühschweiler et al in J. Magn. Reson. 78, 178 (1988) ist es bekannt, zum Refokussieren der Magnetisierung einem weichen 90°-Impuls einen harten 180°-Impuls folgen zu lassen, dem nach einer gewissen Verzögerungszeit, die etwa 60 % der Länge des (beschnittenen) Gauß-Impulses gleich ist, die Datenaufnahme folgt. Eine solche Vergrößerung der Impulslänge ist jedoch unerwünscht, weil dadurch die auf Relaxation zurückzuführenden Verluste erhöht werden. Weiterhin ist diese Lösung nicht dazu geeignet, gekoppelte Spins zu refokussieren. Vielmehr wird der Phasenfehler in solchen Fällen vergrößert, weil der harte 180°-Impuls die Polarisierungen der gekoppelten Partner invertiert und dadurch eine Refokussierung der Kopplungen verhindert. Daher ist dieses Verfahren gänzlich nutzlos, wenn der interessierende Bereich auch nur ein einziges Multiplett enthält, wie es bei der selektiven Version des NOESY-Experiments für kleine Flipwinkel der Fall ist. Man könnte daran denken, anstelle eines harten 180°-Impulses zur Refokussierung einen weichen 180°-Impuls zu verwenden, weil dann die durch Kopplungen bedingte Dephasierung ebenso umgekehrt wird wie auf Verschiebungen zurückzuführende Dephasierungen. Trotzdem werden durch die Anwendung eines weichen 180°-Impulses ebensoviele Probleme geschaffen wie gelöst. Zunächst wird auch hierdurch wiederum die Dauer der Folge unvermeidlich erhöht. Zweitens kann jede Magnetisierung, die während des ersten Impulses in die z-Richtung relaxiert oder die nicht von dem ersten Impuls erregt worden ist, durch den Refokussierungsimpuls erregt werden, so daß eine EXORCYCLE-Phasendrehung des zweiten Impulses wesentlich werden würde, wodurch die Gesamtdauer des Experimentes erhöht würde Daher ist auch dieses, beispielsweise von Bodenhausen et al in J.Magn. Reson. 27, 511 (1977) beschriebene Verfahren nicht immer anwendbar.

In einem Aufsatz von Friedrich et al in J.Magn. Reson. 75, 390 (1987) wurde die Verwendung eines "halben Gauß-Impulses" als Mittel zum Eliminieren von Phasenfehlern bei der selektiven Anregung vorgeschlagen. Obwohl der "halbe Gauß-Impuls" nicht selbst eine Magnetisierung konstanter Phase erzeugt, können Spektren mit konstanter Phase erhalten werden, indem die Resultate zweier Impulsfolgen addiert werden, in denen ein "halber Gauß-Impuls" mit einem harten $180°_x$-Impuls bei alternierenden Abtastungen abwechselt. Diese Folge hat die Wirkung, daß sich die y-Komponenten der Magnetisierung aufheben, während die x-Komponenten erhalten bleiben.

Aus dem eingangs zitierten Artikel von F. Loaiza et al., J. Magn. Reson. 77, 175 (1988) ist die Verwendung von frequenzselektiven, selbstrefokussierenden Anregungsimpulsen bekannt. Insbesondere ist ein rein amplitudenmodulierter 270°-Impuls und ein zugleich amplituden- und phasenmodulierter Impuls beschrieben. Die dort dargestellten, numerisch optimierten Amplitudenmodulationen sind jedoch von der Gaußform verschieden.

Auch in einem Artikel von J. T. Ngo et al. in Biochemical - Society Transactions 14, 1271 (1986) ist ein amplitudenmodulierter, selbstrefokussierender Impuls angegeben, der nominell eine 90°-Anregung bewirkt.

Die Amplitudenmodulation ist aber ebenfalls nicht gaußförmig.

In dem Artikel von R. Freeman et al., J. Magn. Reson. 79, 561 (1988) wird ein selbstrefokussierender 270°(-X) Anregungsimpuls erwähnt. Es findet sich jedoch wiederum kein Hinweis auf die Gaußform.

In der US-A-4,727,324 ist ein Verfahren zum frequenzselektiven, lokalisierten Anregen von NMR-Signalen beschrieben, bei dem in unterschiedlichen Materialtiefen der untersuchten Probe kontinuierlich unterschiedliche Flipwinkel, u. a. auch 270°, der angeregten Kernspins auftreten. In den offenbarten Beispielen wird vorwiegend die Benutzung von üblichen Rechteck-Impulsen zur Anregung behandelt; die Möglichkeit der Anwendung von amplitudenmodulierten Anregungsimpulsen wird erwähnt. Hinsichtlich der Refokussierung der Phasendispersion der durch die Anregung erzeugten transversalen Magnetisierung wird lediglich auf die üblichen Routinen zur Phasenkorrektur hingewiesen.

Demgemäß besteht trotz aller bisher gemachter Anstrengungen das Problem weiter, ein Verfahren zum selektiven Anregen von NMR-Signalen zu finden, bei dem auf einfache Weise eine selbständige Refokussierung der durch die Anregung erzeugten, transversalen Magnetisierung erfolgt, ohne daß damit unerwünschte Nebeneffekte verbunden sind, welche die Anwendung des Verfahrens allgemein erschweren und/oder für bestimmte Experimente sogar unmöglich macht.

Diese Aufgabe wird nach der Erfindung dadurch gelöst, daß der wenigstens eine 270°-Impuls ein frequenzselektiver 270°-Gauß-Impuls ist.

Es hat sich gezeigt, daß die Anwendung eines 270°-Gauß-Impulses anstelle eines 90°-Gauß-Impulses, der von einem harten oder auch weichen 180°-Impuls gefolgt wird, zu einer ausgezeichneten Refokussierung führt, die ohne weitere Maßnahmen Experimente der verschiedensten Art zuläßt. Da der gesamte frequenzselektive Anregungsimpuls "weich" ist, werden insbesondere die Kopplungspartner eines Multipletts nicht gestört, und es wird auch die auf Kopplungen zurückzuführende Entwicklung der Magnetisierung genau in der gleichen Weise refokussiert als wäre sie durch chemische Verschiebungen bedingt.

Der nach der Erfindung angewendete 270°-Gauß-Impuls kann in sämtlichen Verfahren Anwendung finden, wo bisher ein frequenzselektiver 90°-Impuls verwendet worden ist. Der Vorteil der Anwendung des 270°-Gauß-Impulses besteht dann stets darin, daß zusätzliche Maßnahmen zur Refokussierung eingespart werden können und die nachteiligen Wirkungen solcher Maßnahmen nicht auftreten. So kann insbesondere wenigstens einer der in einer NOESY-Impulsfolge enthaltenen frequenzselektiven Anregungsimpulse ein 270°-Gauß-Impuls sein. Natürlich werden vorzugsweise sämtliche frequenzselektive Anregungsimpulse von 270°-Gauß-Impulsen gebildet.

Ähnlich wie in der zweidimensionalen NMR-Spektroskopie kann ein 270°-Gauß-Impuls auch in den bilderzeugenden Impulsfolgen bei der NMR-Tomographie Anwendung finden. Wenn die frequenzselektiven Anregungsimpulse unter einem zur Volumenselektion dienenden Gradienten eingestrahlt werden, werden die bisher üblichen Gradienten-Umkehrungen nach dem Anregungsimpuls eingespart. Das Entsprechende gilt dann auch für die Volumenselektion, die für die NMR-Spektroskopie in ausgewählten Volumenelementen eines Körpers erforderlich ist, bei der dann auch wieder wenigstens einer der in der volumenselektiven Impulsfolge enthaltenen frequenzselektiven Anregungsimpulse ein 270°-Gauß-Impuls sein kann.

Die theoretischen Grundlagen und Beispiele für nach dem erfindungsgemäßen Verfahren verwendete Impulsfolgen sind in der folgenden Beschreibung an Hand der in der Zeichnung dargestellten Diagramme näher beschrieben und erläutert. Es zeigen

Fig. 1 eine perspektivische Darstellung des Magnetisierungs-Verlaufs im Raum für einen 90°-Gauß-Impuls,

Fig. 2 die Projektion des Magnetisierungs-Verlaufes nach Fig. 1 in die xy-Ebene,

Fig. 3 ein Diagramm des Magnetisierungs-Verlaufes ähnlich Fig. 1 für einen 270°-Gauß-Impuls,

Fig. 4 die Projektion des Magnetisierungs-Verlaufes nach Fig. 3 in die xy-Ebene,

Fig. 5 ein Diagramm, das die Größe der transversalen Magnetisierung als Funktion der reduzierten Verschiebung für einen 90°- und einen 270°-Gauß-Impuls angibt,

Fig. 6 ein Diagramm, welches das Phasenverhalten in dem Bereich kleiner Verschiebungen für einen 90°- und einen 270°-Gauß-Impuls angibt,

Fig. 7 ein Diagramm, das den Vergleich zwischen dem simulierten und dem experimentellen Amplitudenverhalten eines 270°-Gauß-Impulses als Funktion einer reduzierten Verschiebung wiedergibt,

Fig. 8 ein Diagramm, das das Fig. 7 entsprechende Phasenverhalten wiedergibt,

Fig. 9 das Spektrum des Methylesters von trans-2-Phenylcyclopropancarbonsäure, das mit einem harten 90°-Impuls erhalten wurde,

Fig. 10 das Spektrum des M-Multiplets der gleichen Verbindung nach einer Anregung mit einem 90°-Gauß-Impuls und ohne Phasenkorrektur;

Fig. 11 das gleiche Spektrum wie Fig. 10 mit starker, frequenzabhängiger Phasenkorrektur,

Fig. 12    das Spektrum des gleichen M-Multipletts, jedoch nach Anregung mit einem 270°-Gauß-Impuls und ohne Phasenkorrektur,

Fig. 13    ein weiches NOESY-Spektrum eines Diagonal-Multipletts des Methylesters von trans-2-Phenylcyclopropancarbonsäure unter Verwendung von drei 90°-Gauß-Impulsen,

Fig. 14    das gleiche Spektrum wie in Fig. 13, das jedoch durch Anregung mit drei 270°-Gauß-Impulsen erhalten wurde,

Fig. 15    das unter den gleichen Bedingungen wie das Spektrum nach Fig. 14 aufgenommene Spektrum eines Außerdiagonal-Multipletts,

Fig. 16    das Zeitablaufschema von Gradienten für selektive Manipulationen der Magnetisierung,

Fig. 17    Profile der $M_z$-Magnetisierung, die durch die Einwirkung von y-Impulsen auf die bei Impulsbeginn exakt längs der x-Achse ausgerichtete transversale Magnetisierung erzeugt werden,

Fig. 18    die 2-dimensionale räumliche Selektivität von 90°- und 270°- Gauß-Impulsen,

Fig. 19    die Phasenentwicklung einer Familie von Magnetisierungsvektoren unter 90°- und 270°- Gauß-Impulsen,

Fig. 20    die Zeitabhängigkeit des Kippwinkels $\Theta$ des effektiven Feldes für einen nicht-resonanten Vektor während eines 270°- Gauß-Impulses mit 2,5% Abbruch,

Fig. 21    das für einen 270°- Gauß-Impuls für ein befriedigendes Profil erforderliche Abbruchsniveau als Funktion der Gradienten-Anstiegsdauer $t_g/t_p$,

Fig. 22    Impuls- und Feldgradientenschemata für
    a) volumenselektive Anregung (VSE)
    b) räumlich und mit der chemischen Verschiebung codierte Anregung (SPACE)
    c) räumlich aufgelöste Spektroskopie (SPARS),

Fig. 23
    a) selbstrefokussierende SPARS (= SR-SPARS)
    b) selbstrefokussierende SPACE (= SR-SPACE),

Fig. 24
    a) ein Impuls- und Feldgradientenschema für selektive Volumen Anregung mit stimulierten Echos (VEST),
    b) Kohärenztransferwege für die stimulierten Echos,

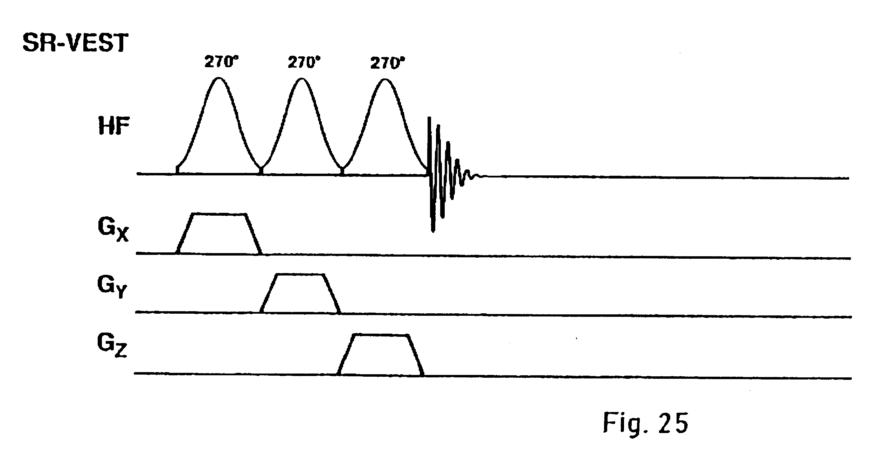

Fig. 25    ein Impuls- und Gradientenschema für selbstrefokussierende VEST (= SR-VEST), und

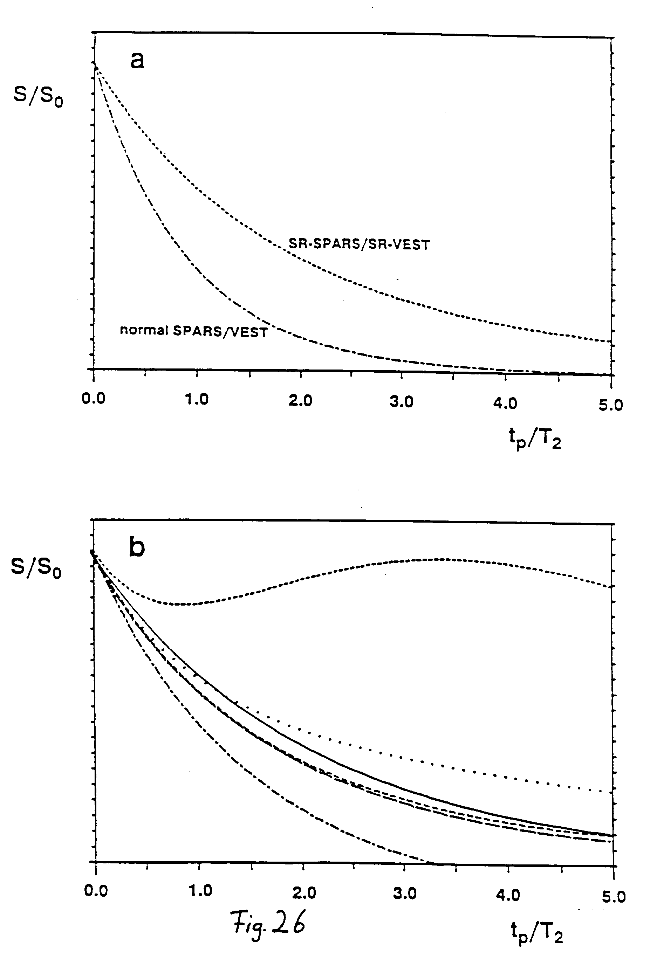

Fig. 26    die relative Signalintensität S/So als Funktion des dimensionslosen Verhältnisses $t_p/T_2$ der Gauß-Impulsdauer $t_p$ und der transversalen Relaxationszeit $T_2$.

Es ist ohne weiteres ersichtlich, daß im Falle eines jeden langen, selektiven Impulses geringer Intensität außerhalb der Resonanz liegende Effekte nicht vernachlässigt werden dürfen.

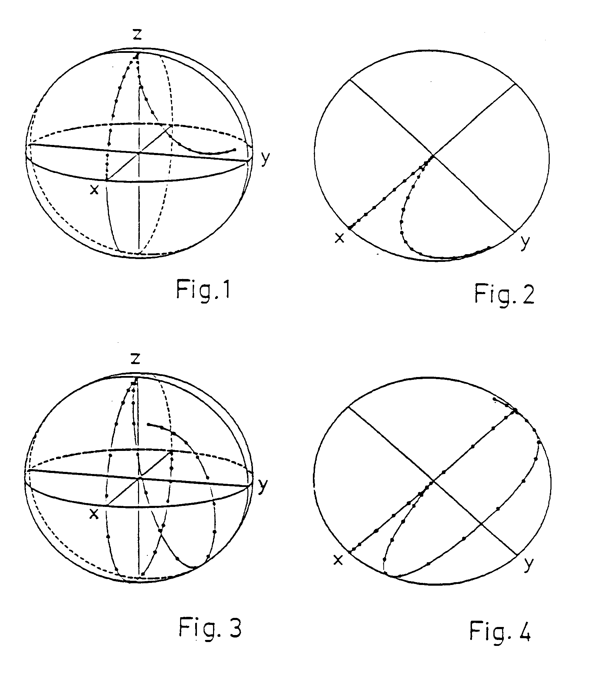

In dieser Hinsicht ist es von Interesse, genau zu betrachten, was mit einem einzelnen Magnetisierungsvektor in jedem Stadium eines 90°-Gauß-Impulses geschieht. Zu Beginn des Gauß-Impulses ist das magnetische Feld $B_1$ sehr gering und die Bewegung eines Vektors, der sich nur wenig neben der Resonanz befindet, erfolgt im wesentlichen rund um die z-Achse. In diesem Stadium ist auch die Größe der transversalen Magnetisierung klein, und eine Rotation um die z-Achse hat nur eine geringe Wirkung auf die endgültige Magnetisierung. Das $B_1$-Feld und der Kippwinkel wachsen dann an, bis das $B_1$-Feld in der Mitte des Impulses sein Maximum erreicht. Der sich in Resonanz befindliche Vektor ist dann um 45° aus der z-Achse herausgedreht und die Rotation eines neben der Resonanz liegenden Vektors erfolgt dann vornehmlich um das $B_1$-Feld an dieser Stelle. Während des letzten Teiles des Impulses, während sich der in Resonanz befindliche Magnetisierungsvektor der x,y-Ebene nähert, nimmt das $B_1$-Feld ab. Während dieses Teiles des Impulses ist die Dephasierung der neben der Resonanz liegenden Magnetisierung am stärksten, weil die auf die Frequenzabweichung zurückzuführende Rotation dominiert und die Transversalkomponente der Magnetisierung groß ist. Diese Situation wird durch eine Betrachtung der Magnetisierungsbahnen leicht verständlich. Fig. 1 zeigt das gut bekannte "Grapefruit-Diagramm", in dem die Bahnen der Magnetisierungsvektoren dargestellt sind, die sich entweder in Resonanz befinden oder gegenüber der Resonanzfrequenz eine reduzierte Verschiebung von 0,11 aufweisen. Die Definition hierfür ist ein $n\Omega/\omega_1^{max}$ mit $n = 2\beta/\pi$ (d.h. $n = 1$ für $\beta = 90°$ und $n = 3$ für $\beta = 270°$). Die "reduzierte Verschiebung" ist so definiert, daß das Verhalten einer Magnetisierungskomponente mit der gleichen absoluten Verschiebung unter Gauß-Impulsen verglichen wird, welche die gleiche Breite haben und die sich nur um eine dreifache Erhöhung von $\omega_1^{max}$ für den 270°-Gauß-Impuls im Vergleich zum 90°-Gauß-Impuls unterscheiden. Die zeitliche Entwicklung der Bahnen ist durch Punkte angegeben, die gleichen Zeitintervallen zugeordnet sind. Fig. 2 zeigt die gleichen Bahnen, in die x,y-Ebene projiziert. Es ist zu beachten, daß die Bahn der frequenzverschobenen Magnetisierung bis nahe dem Ende des Impulses ziemlich dicht an der x,z-Ebene bleibt und erst dann eine ziemlich schnelle Dephasierung eintritt. Weiterhin ist zu bemerken, daß die Größe der Magnetisierung in der x,y-Ebene noch immer sehr bedeutend ist und etwa 95% des Wertes im Resonanzfall beträgt, jedoch etwa 80° außer Phase ist.

Es sei nun die gleiche Situation für einen Gauß-Impuls betrachtet, der die gleiche Dauer hat, jedoch im Resonanzfall einen Flipwinkel von 270°. Das $B_1$-Feld ist hier dreimal so stark wie für einen 90°-Impuls. Die Betrachtungen, die für den ersten Teil des Impulses gelten, sind im wesentlichen die gleichen wie beim 90°-Impuls. Das $B_1$-Feld ist niedrig und die auf die Frequenzverschiebung zurückzuführende Rotation dominant. Da jedoch die transversale Magnetisation klein ist, hat dies eine nur geringe Wirkung. Wenn $B_1$ das Maximum erreicht, ändern sich die Verhältnisse gegenüber dem vorhergehenden Fall, weil die sich in Resonanz befindende Komponente nun mit der z-Achse einen Winkel von 135° bildet. Wenn der frequenzverschobene Magnetisierungsvektor die x,y-Ebene durchläuft und die Dephasierungseffekte ihren Höhepunkt erreichen, ist das effektive Feld in diesem Fall näher an der x,y-Ebene als im Falle des 90°-Impulses. Als Ergebnis findet eine geringere Dephasierung der Magnetisierung statt als im Fall des 90°-Impulses. Der nächste bedeutende Zeitpunkt tritt ein, wenn der sich in Resonanz befindende Vektor den Südpol passiert. An dieser Stelle beginnt die sich nicht in Resonanz befindende Magnetisierung, die sich zuvor von dem in Resonanz befindenden Vektor entfernt hatte, in Richtung auf die -x-Achse zu konvergieren. Wenn sich die Magnetisierung zur -x-Achse bewegt, wird das $B_1$-Feld zunehmend schwächer, so daß die auf die Frequenzverschiebung zurückzuführende Rotation erneut stärker wird. Ähnlich wie im Fall des 90°-Gauß-Impulses hat diese Bewegung eine starke Wirkung, weil die Größe der transversalen Magnetisierung an dieser Stelle stark ist. Während für den 90°-Gauß-Impuls hierin die Hauptquelle für den Phasenfehler lag, hat im Falle eines 270°-Gauß-Impulses die Magnetisierung den größten Teil ihrer Zeit in den ersten beiden Quadranten verbracht, wo eine Dephasierung eintrat, so daß die erhöhte Rephasierung im dritten Quadranten während des letzten Teiles des 270°-Gauß-Impulses tatsächlich hilfreich ist, um eine Refokussierung der Magnetisierung zu bewirken. Daher ist zu erwarten, daß die gleichen Eigenschaften, die zu einer Erhöhung des Phasenfehlers bei einem 90°-Gauß-Impuls führen, eine Reduzierung des Phasenfehlers bei einem 270°-Gauß-Impuls bewirken. Auch dies ist bei einer Betrachtung der Magnetisierungsbahnen leicht erkennbar, und es zeigen die Fig. 3 und 4 das "Grapefruit-Diagramm" bzw. die Projektion in die x,y-Ebene der Magnetisierungsvektoren mit der gleichen reduzierten Frequenzverschiebung, wie sie den Fig. 1 und 2 zugrundeliegen, jedoch in diesem Fall berechnet für einen 270°-Gauß-Impuls. Es ist zu beachten, daß die frequenzverschobene Magnetisierung während des mittleren Teiles des Impulses nahezu parallel zur x,z-Ebene verläuft und gegen Ende des Impulses zur -x-Achse refokussiert wird. Es sei noch erwähnt, daß die in den Fig. 1 bis 4 wiedergegebenen Magnetisierungsbahnen durch eine numerische Lösung der Blochschen Gleichungen gewonnen worden sind und die Punkte gleichen Zeitintervallen entsprechen. Die verwendeten Gauß-Impulse waren bei 5% abgebrochen.

Für Impulse konstanter Amplitude sind die Bewegungsgleichungen für die Magnetisierung einfach, weil die Magnetisierung um ein konstantes effektives Feld rotiert, das gegenüber der x,y-Ebene geneigt ist, und es können die Wirkungen aller Impulse mit konstanter Amplitude leicht berechnet werden. Für amplitudenmodulierte Impulse wird die Situation komplizierter, weil das effektive Feld einen zeitabhängigen Kippwinkel aufweist, so daß die Vorhersage der Wirkungen eines solchen Impulses analytisch schwierig ist. Abgesehen von einigen speziellen Fällen muß zu Näherungen Zuflucht genommen werden. Da die gewöhnlich benutzte, auf der Fourier-Transformation beruhende Näherung häufig irreführend ist, wird die einzige sichere Näherung bevorzugt, nämlich die auf einer numerischen Lösung der Blochschen Gleichungen beruhende. Eine Fourier-Näherung würde anzeigen, daß es keinen Unterschied im Phasenverhalten bei einer Anregung durch einen 90°- oder 270°-Impuls gibt. Tatsächlich ist jedoch ein grundsätzlicher Unterschied zwischen den beiden Impulsen vorhanden.

Lösungen der Blochschen Gleichungen können leicht iterativ erhalten werden, indem die Umhüllende des Impulses in viele gleiche Intervalle unterteilt und angenommen wird, daß die Amplitude in jedem Intervall konstant ist. Alle hier behandelten Simulationen sind auf diese Weise berechnet, einschließlich der vorstehend behandelten Magnetisierungs-Bahnen. Der Hauptnachteil dieser Methode besteht darin, daß sie nicht eine intuitive Methode zur Ermittlung der Impulsform liefert, obwohl sie stets eine korrekte Antwort auf dieses Problem gibt.

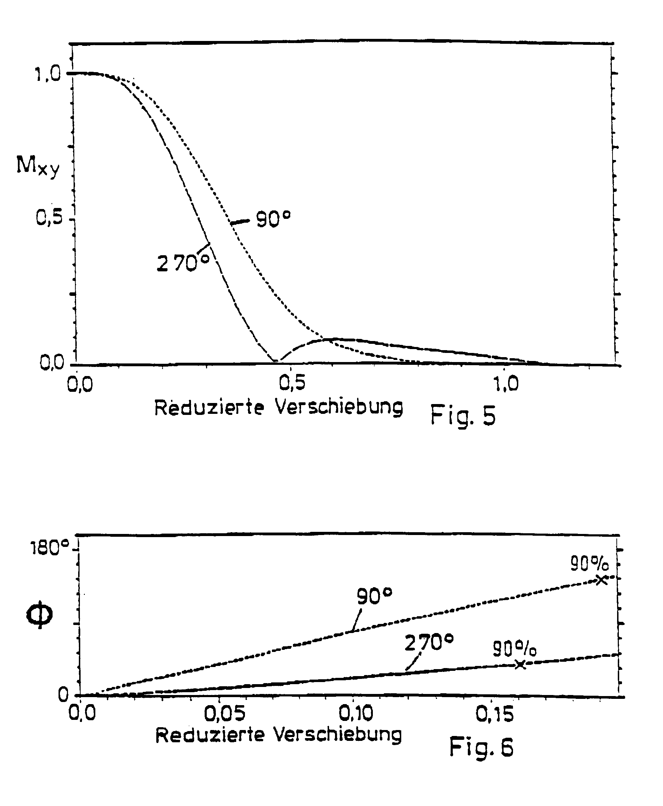

Fig. 5 veranschaulicht die erwartete Signalamplitude bei Anregung durch einen 90°- (kurzgestrichelt) und einen 270°-Gauß-Impuls (langgestrichelt). Alle Berechnungen wurden für Impulse der gleichen Dauer durchgeführt, so daß der einzige Unterschied zwischen dem 90°- und dem 270°-Impuls in einer Verdreifachung der Amplitude besteht. In erster Näherung sagt die Simulation voraus, daß der 270°-Gauß-Impuls etwas selektiver ist als der 90°-Gauß-Impuls gleicher Dauer. Diese marginale Erhöhung der Selektivität ist aufgrund von auf der Fourier-Transformation beruhenden Betrachtungen nicht zu erwarten, jedoch ist diese erhöhte Selektivität durchaus willkommen. Die Simulation läßt weiter erwarten, daß der 270°-Gauß-Impuls einen Nebenzipfel geringer Intensität aufweist, und auch diese Eigenschaft war aufgrund der Fourier-

5

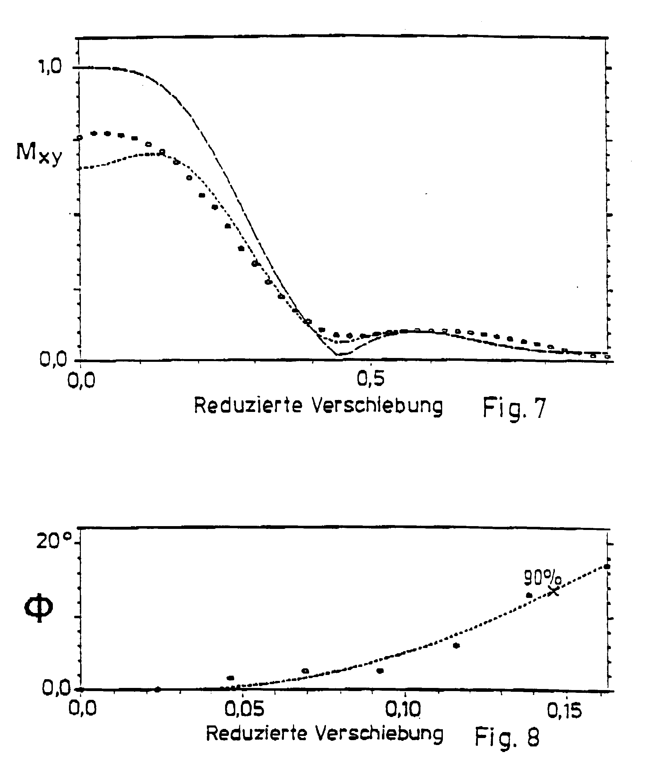

Transformation nicht zu erwarten. Fig. 7 veranschaulicht das simulierte Verhalten eines 270°-Gauß-Impulses (kurzgestrichelt mit, langgestrichelt ohne Berücksichtigung der Effekte der $B_1$-Inhomogenität) zum experimentellen Verhalten (Kreise), und es ist eine gute Übereinstimmung feststellbar.

Fig. 6 zeigt das berechnete Phasenverhalten im zentralen Bereich der Anregung für 90°- (kurzgestrichelt) und 270°-Gauß-Impulse (langgestrichelt). Es ist einleuchtend, daß im Gegensatz zum 90°-Gauß-Impuls, der einen sehr steilen Phasengradienten hat, der 270°-Gauß-Impuls in diesem Bereich ein nahezu ebenes Phasenverhalten zeigt. Es ist besonders wichtig festzustellen, daß im nützlichen Bereich der Anregung, die im Bereich von 100 % bis 90 % der Maximalamplitude der Anregung liegt, der Phasenfehler des 270°-Gauß-Impulses weniger als 1/4 des Phasenfehlers des 90°-Gauß-Impulses beträgt. Wie mehr im einzelnen aus dem in Fig. 8 veranschaulichten experimentellen Ergebnis (Kreise) hervorgeht, ist der Phasenfehler in diesem Bereich kleiner als 15°, was in guter Übereinstimmung mit den berechneten Werten (kurzgestrichelt) steht.

Fig. 7 zeigt weiterhin, daß es geringe Unterschiede zwischen dem experimentellen und dem berechneten Verhalten eines 270°-Gauß-Impulses gibt. Der deutlichste Unterschied scheint darin zu liegen, daß die durch die Simulation vorhergesagte Nullstelle geglättet erscheint und daß die Magnetisierung bei Resonanz etwas geringer ist als die mit einem harten Impuls erreichte Intensität. Diese Abweichungen können jedoch leicht durch die Inhomogenität des $B_1$-Feldes erklärt werden. Es ist bekannt, daß Probenköpfe für die hochauflösende Spektroskopie gewöhnlich für einen hohen Füllfaktor konstruiert werden, um eine möglichst hohe Empfindlichkeit zu erreichen, selbst auf Kosten der Homogenität des $B_1$-Feldes. Es wurden Nutations-Versuche mit einer 5 mm-Protonen-Probe ausgeführt, die eine Verteilung des HF-Feldes anzeigen, die durch eine Lorentzsche Näherung mit einer Halbhöhen-Breite $\Delta B_1 \approx 0,1 \langle B_1 \rangle$ angegeben werden kann. Wenn diese Beziehung in das Simulationsprogramm eingegeben wird, ist die Übereinstimmung zwischen Experiment und Simulation sehr viel besser, wie es Fig. 7 zeigt. Obwohl die $B_1$-Inhomogenität bei einem 270°-Gauß-Impuls einen Empfindlichkeitsverlust von etwa 20 % verursacht, erscheint dies jedoch ein sehr kleiner Preis für die deutlich verbesserten Phaseneigenschaften zu sein.

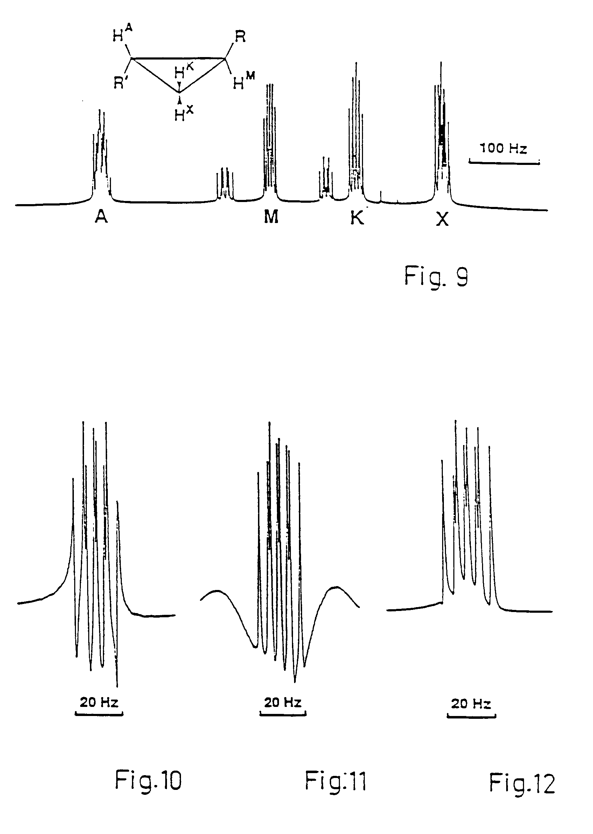

Die erheblichen Vorteile, die mit dem erfindungsgemäßen Verfahren erzielt werden können, zeigen sich in der praktischen Anwendung. In den Fig. 9 bis 12 sind Spektren des Methylesters der trans-2-Phenylcyclopropancarbonsäure vergleichend nebeneinander gestellt, die mit einem harten 90°-Impuls, einem 90°-Gauß-Impuls ohne Phasenkorrektur, einem ebensolchen mit starker, frequenzabhängiger Phasenkorrektur und einem erfindungsgemäßen 270°-Gauß-Impuls ohne Phasenkorrektur aufgenommen wurden. Als weitere Beispiele wurden Versuche mit selektiven zweidimensionalen Austausch-Spektren eines skalar gekoppelten Spinsystems gemacht (Soft-NOESY). Das normale NOESY-Experiment mit kleinen Flipwinkeln besteht aus einer Folge von drei nicht selektiven Impulsen:

$$90° - t_1 - 20° - \tau_m - 20° - t_2 \qquad [1].$$

Wenn selektive Impulse benutzt werden, kann diese Sequenz durch die folgende Sequenz ersetzt werden:

$$90°_{Gauss}(\Omega_A) - t_1 - 90°_{Gauss}(\Omega_A) - \tau_m - 90°_{Gauss}(\Omega_Z) - t_2 \qquad [2].$$

Die in Klammern angegebenen Frequenzen sind die Frequenzen des HF-Trägers der selektiven Impulse, welche Frequenzen zu den chemischen Verschiebungen zentriert sein sollten, die der Mitte der interessierenden Multipletts entsprechen. Für ein diagonales Multiplett AA gilt $\Omega_Z = \Omega_A$ und für ein Kreuz-Peak Multiplett AX gilt $\Omega_Z = \Omega_X$ und so weiter. Unter Verwendung von 270°-Gauß-Impulsen wird die Sequenz einfach zu

$$270°_{Gauss}(\Omega_A) - t_1 - 270°_{Gauss}(\Omega_A) - \tau_m - 270°_{Gauss}(\Omega_Z) - t_2. \qquad [3].$$

Während in dieser Sequenz der erste und der letzte Impuls einfach dazu dienen, die longitudinale Polarisation in eine transversale Magnetisierung umzuwandeln, hat der zweite Impuls den Zweck, den umgekehrten Prozeß zu bewirken. Es versteht sich, daß dann, wenn ein von Phasenverzerrungen freier Impuls, wie ein 270°-Gauß-Impuls, dazu geeignet ist, eine $M_z$-Polarisation beispielsweise in eine reine $M_x$-Magnetisierung ohne nennenswerte Phasendispersion umzuwandeln, daß dann der gleiche Impuls auch in der Lage ist, die $M_x$-Komponenten der Magnetisierung, also die Projektion der Transversal-Magnetisierung auf die x-Achse, in eine longitudinale $M_z$-Polarisation zurückzuverwandeln.

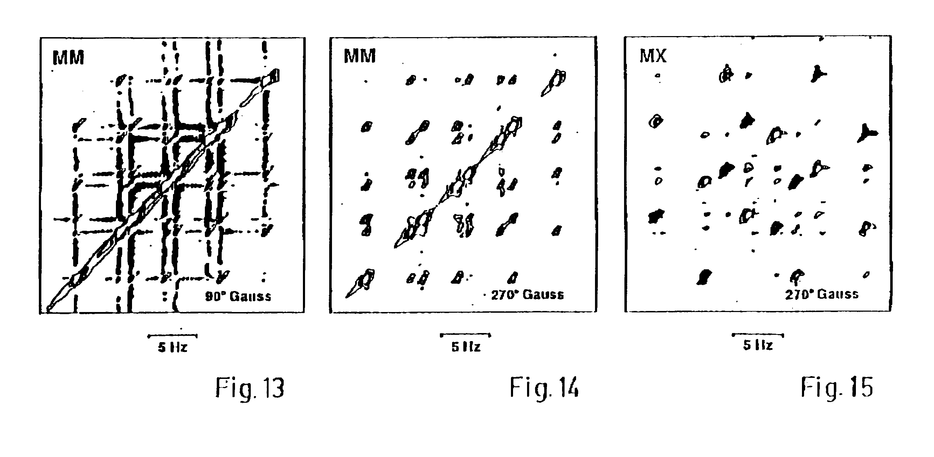

Wenn das Soft-NOESY-Experiment mit 90°-Gauß-Impulsen durchgeführt wird, ist es erforderlich, eine zweidimensionale Korrektur fünfter Ordnung vorzunehmen. Hierbei handelt es sich keineswegs um eine triviale Operation. Fig. 13 und 14 zeigen die Spektren des MM-Diagonal-Multipletts einer Probe des Methylesters von trans-2-Phenylpropancarbonsäure, die mit den Soft-NOESY-Folgen nach den Gl. [2] und [3] unter Verwendung von 90°- bzw. 270°-Gauß-Impulsen mit einem Bruker-Spektrometer vom Typ AM 400 erhalten wurden, das mit einer Einrichtung zur selektiven Anregung der Firma Oxford Research Systems ausgestattet war. Es wurde versucht, unter Anwendung von Korrekturen erster Ordnung das erste Spektrum in Phase zu bringen, woraus sich unvermeidlich ein starkes Rollen der Grundebene des Spektrums ergab, wodurch die außerhalb der Diagonale liegenden Komponenten geringer Intensität des Multipletts verdeckt wurden. Dagegen wurden bei dem zweiten Spektrum nach Fig. 14 keine phasenabhängigen Korrekturen vorgenommen. Die Differenz zwischen den beiden Spektren spricht für sich selbst. Fig. 15 zeigt ein Spektrum der MX-Kreuzlinie der gleichen Verbindung, das mit 270°-Gauß-Impulsen aufgenommen wurde. Auch hier sind die Resultate ausgezeichnet, ohne daß zu einer frequenzabhängigen Phasenkorrektur Zuflucht genommen werden mußte.

Das dargestellte selektive NOESY-Experiment ist vorwiegend für quantitative Untersuchungen bestimmt. Dabei ist es wichtig, keine Verzerrungen in das Spektrum einzuführen, und es zeigt sich, daß die Anwendung von 270°-Gauß-Impulsen das beste Mittel darstellt, um bei den selektiven Versionen des NOESY-Experiments dieses Ziel zu erreichen.

Ebenso wie bei dem vorstehend behandelten Soft-NOESY-Experiment ist die Anwendung des 270°-Gauß-Impulses überall dort von Vorteil, wo bisher ein selektiver 90°-Gauß-Impuls Anwendung gefunden hat, wie beispielsweise auch bei selektiven TOKSI-, TOE- und insbesondere zweidimensionalen Experimenten. Ebensolche Vorteile ergeben sich auch dann, wenn selektive Anregungsimpulse in Verbindung mit einem Feldgradienten zum Zweck einer Scheibenselektion Verwendung finden. Ein 270°-Gauß-Impuls zur selektiven Anregung eines durch einen Feldgradienten ausgewählten Bereiches kann die bei Anwendung eines üblichen 90°-Gauß-Impulses notwendige Bildung eines Feldechos entbehrlich machen. Daher ist die Anwendung von 270°-Gauß-Impulsen anstelle von 90°-Gauß-Impulsen in den in der NMR-Tomographie zur Bilderzeugung üblichen Impulsfolgen angezeigt. Entsprechendes gilt auch dann, wenn durch eine mehrfache Scheibenselektion in verschiedenen Richtungen ein Volumenelement eines größeren Körpers selektiv angeregt werden soll, um das NMR-Spektrum dieses Volumenelementes zu untersuchen.

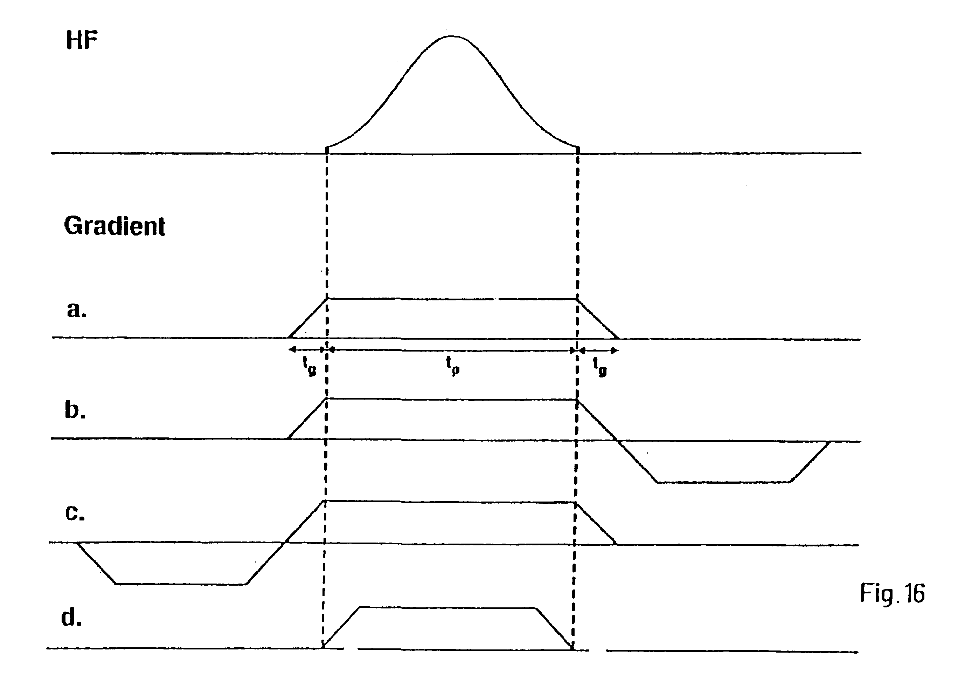

Es ist seit längerem bekannt, daß die selektive Anregung eines engen Frequenzbandes in einem inhomogen verbreiterten Spektrum eine nicht-triviale Angelegenheit ist. Tatsächlich führt die endliche Länge eines selektiven HF-Impulses zu einer Dispersion der Phasen der transversalen Magnetisierungsvektoren, die sich während des Impulses aufbaut. In Anwesenheit einer kontinuierlichen Verteilung von Verschiebungen wird es eine Verteilung von effektiven Feldern geben, die einen kontinuierlichen Bereich von Kippwinkeln bezüglich der Z-Achse des rotierenden Koordinatensystems aufspannen. Folglich wird sich die Magnetisierung am Ende eines HF-Impulses mit einem kleinen On-Resonance Flippwinkel, der gemäß dem Schema von Fig. 16a angelegt wurde, fast vollständig dephasiert haben, was zu einem nahezu verschwindenden Signal nach Abschalten des Gradienten führt. Der HF-Impuls in Fig. 16 ist ein abgebrochener Gauß-Impuls, aber die Gradientenszenarios könnten auch mit anderen Impulsformen kombiniert werden. Fig. 16a zeigt einen selektiven Impuls zur Konvertierung von $M_z$ in $M_{xy}$ oder umgekehrt in Anwesenheit eines Feldgradienten ohne Kompensation der Phasenfehler; Fig. 16b zeigt eine selektive Anregung (zur Konvertierung von $M_z$ in $M_{xy}$) mit Refokussierung der transversalen Magnetisierung durch Gradientenumkehr, um die Phasendispersion zu kompensieren, die sich während des Impulses aufbaut; Fig. 16c zeigt einen selektiven Impuls zur Konvertierung von $M_{xy}$ in $M_z$ mit Kompensation des Phasenfehlers durch Prä-Defokussierung der transversalen Magnetisierung durch Umkehrung des Gradienten vor Impulsbeginn; Fig. 16d zeigt das gleiche wie Fig. 16a, aber der Feldgradient wird an- und ausgeschaltet während der Gradientenanstiegszeiten $t_g$ innerhalb der Zeitdauer $t_p$ des abgebrochenen Gauß-Impulses.

Die meisten selektiven Impulse, sowie diejenigen mit Gauß-, Sinc- oder Hermite-Form führen glücklicherweise zu einer transversalen Magnetisierung mit einem nahezu linearen Phasengradienten als Funktion der Verschiebung während der Einwirkung auf die Z-Magnetisierung. Es ist daher möglich, diese Phasendispersion durch Refokussierung zu beseitigen, entweder durch Anwendung eines nicht-selektiven 180°-Impulses oder durch Umkehrung des magnetischen Feldgradienten wie in Fig. 16b gezeigt. Gradientenumkehr ist üblicherweise zu bevorzugen, da sie die Komplikationen vermeidet, die von der hohen, bei 180°-Impulsen erforderlichen HF-Leistung erwachsen, die natürlich stark genug sein müssen, um OFF-Resonance-Effekte zu überspielen. Falls nicht-selektive Impulse insgesamt vermieden werden, wie in stimulierten Echotechniken, wird eine Multi-Volumen-Spektroskopie möglich durch Verschiebung des zu beobachtenden Volumens (VOI = Volume of Interest) in ein anderes Gebiet der Probe, solange alle drei Koordinaten des zweiten VOI von denen des ersten differieren.

Viel Mühe wurde auf die Entwicklung von Pulsformen für die selektive Konversion von $M_z$ in $M_{xy}$ mit dem Ziel einer "Top Hat" Frequenzantwort verwendet. Die meisten dieser Forschungsarbeiten haben natürlich wenig Aufmerksamkeit auf die Phasenantwort gerichtet, in der Annahme, daß die Refokussierung der Magnetisierung nach dem Impuls möglich sein würde. Falls es jedoch der Zweck des Impulses ist, selektiv die transversale $M_{xy}$-Magnetisierung zur Z-Achse zurückzudrehen, wie bei SPARS (Spatially Resolved Spectroscopy) oder VEST (Selected Volume Excitation Using Stimulated Echoes), wird die Phasendispersion bedeutungsvoller. Natürlich ist es unmöglich, die Magnetisierung zu refokussieren, wenn sie einmal längs der Z-Achse des rotierenden Koordinatensystems ausgerichtet ist, und daher ist es notwendig, die Phasenverteilung der Magnetisierungsvektoren in der transversalen Ebene in geeigneter Weise vor Anlegen des Impulses zu präparieren.

In unserer obigen Diskussion der Auswirkungen von 270°- Gauß - Impulsen haben wir nur Impulse berücksichtigt, die auf eine Gleichgewichts-Z-Magnetisierung einwirken. Glücklicherweise ist es möglich, wenn man die Auswirkung eines Impulses auf die Z-Magnetisierung kennt, analytisch zu zeigen, wie sie sich auf die transversale Magnetisierung auswirkt. Man kann beweisen, wenn ein reeller (d.h. phasenkonstanter) Impuls mit einer zeit - symmetrischen Einhüllenden längs der Y-Achse konkurrierend mit einem zeitsymmetrischen amplitudenmodulierten Feldgradienten (der ein Magnetfeld längs der Z-Achse erzeugt) angelegt wird, daß dann die Magnetisierung eine totale Drehung $R_{tot}$ um eine Achse erfährt, die in der YZ-Ebene liegen muß. Daher ist für einen gegebenen Magnetisierungsvektor das Problem exakt gleichwertig mit der Drehung, die unter einem Konstant-Amplituden-Impuls in Anwesenheit eines konstanten Feldes erzeugt wird. Tatsächlich existiert keine einfache Möglichkeit, die Amplitude des effektiven Feldes $B_{eff}$, des effektiven Flippwinkels $\beta_{eff} = -\gamma B_{eff} \cdot t_p$ oder des effektiven Drehwinkels $\Theta_{eff}$ analytisch zu bestimmmen, aber das ist für die vorliegende Diskussion nicht notwendig. Es genüge, anzumerken, daß für eine gegebene Verschiebung von der Resonanz und für eine gegebene Impulsform $\beta_{eff}$ und $\Theta_{eff}$ konstant sind. Es kann leicht gezeigt werden, daß, wenn ein Impuls mit gegebenen $\beta_{eff}$ und $\Theta_{eff}$ in der YZ-Ebene auf die ursprüngliche, längs der Z-Achse ausgerichtete Magnetisierung $M^0$ einwirkt, sich die resultierende Magnetisierung

$$M_x^r = M^0 \sin\beta_{eff} \sin\theta_{eff}$$
$$M_y^r = M^0 (1 - \cos\beta_{eff}) \sin\theta_{eff} \cos\theta_{eff}$$
$$M_z^r = M^0 (\cos^2\theta_{eff} + \cos\beta_{eff} \sin^2\theta_{eff}).$$

$$[4]$$

ergibt. Wenn andererseits der gleiche Impuls auf eine längs der -X-Achse ausgerichtete Magnetisierung $M^0$ einwirkt, ergeben sich die resultierenden Komponenten als

$$M_x^r = -M^0 \cos\beta_{eff}$$
$$M_y^r = -M^0 \sin\beta_{eff} \cos\theta_{eff}$$
$$M_z^r = M^0 \sin\beta_{eff} \sin\theta_{eff}.$$

$$[5]$$

Aus den Gleichungen [4] und [5] wird klar, daß die $M_z$-Antwort eines Impulses, der auf die -x-Magnetisierung einwirkt, exakt dieselbe ist wie die $M_x$-Antwort eines Impulses, der auf die Z-Magnetisierung einwirkt. Daher wird das Scheibenprofil, das durch einen 270°-Gauß-Impuls (oder für diesen Zweck irgendeinen Impuls, der die obigen Bedingungen erfüllt) ausgewählt wurde, immer das gleiche sein, gleichgültig, ob er auf eine Magnetisierung einwirkt, die ursprünglich längs der $M_x$- oder der $M_z$-Achse ausgerichtet war. Die resultierende Magnetisierung wird einfach längs einer anderen Achse gespeichert.

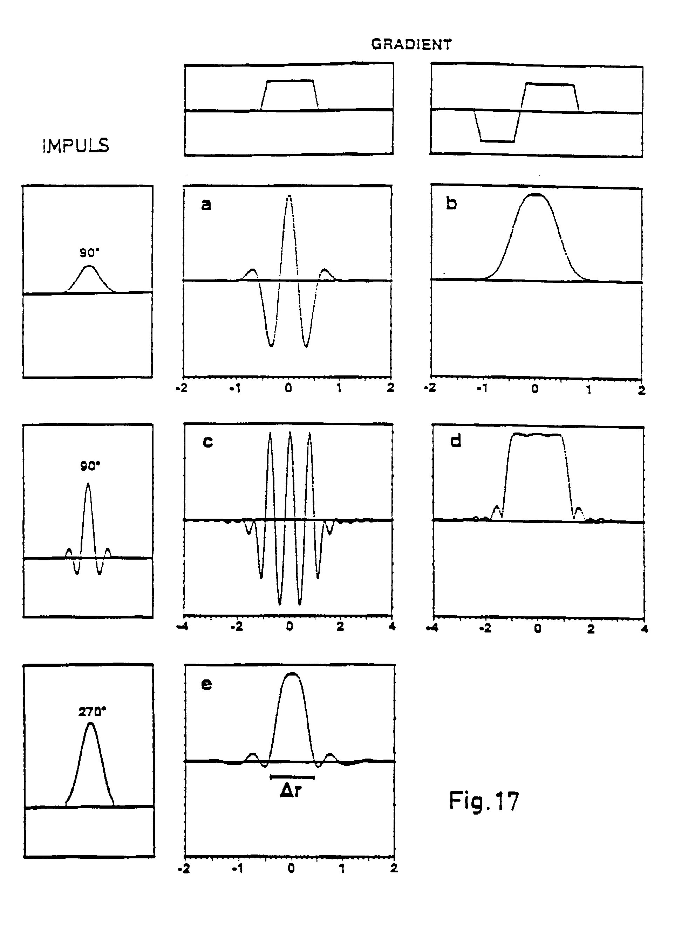

Fig. 17a und 17c zeigen die $M_z$-Profile für 90°-Gauß- und 90°-Sinc-förmige Impulse, die auf die -X-Magnetisierung einwirken, wobei angenommen wird, daß letztere vor Anlegen der selektiven Impulse gleichförmig über das ganze Objekt angeregt war. Der Einfachheit halber wird angenommen, daß die Gradienten instantan geschaltet werden können. Die horizontalen Achsen sind linear proportional zum Abstand r vom Zentrum der Scheibe in einer Richtung parallel zum angelegten Feldgradienten. Nach den obigen Überlegungen beschreiben diese Simulationen auch die X-Magnetisierungs-Profile, die erhalten werden, wenn die gleichen Impulse auf eine Gleichgewichts-Z-Magnetisierung einwirken. Die unerwünschten Profile der selektiven 90°-Impulse sind ein direktes Resultat der Dephasierung während des Impulses. Falls die erforderliche Transformation diejenige von $M_z$ nach $M_x$ ist, kann das Profil durch Refokussierung gemäß dem Schema von Fig. 16b bedeutend verbessert werden.

Falls die erforderliche Transformation diejenige von $M_x$ in $M_z$ ist, ist eine Refokussierung nicht möglich, aber eine gangbare Alternative ist eine Prä-Defokussierung. Diese besteht im Anlegen eines Feldgradienten zur Erzeugung einer Phasendispersion der transversalen Magnetisierung vor dem Anlegen des HF-Impulses gemäß dem Schema von Fig. 16c. Man erkennt aufgrund der obigen Symmetrieargumente, daß die Phasendispersion, die auf diese Weise erzeugt wurde, entgegengesetzt gleich zur Phasendispersion sein sollte, die von einem gegebenen Impuls erzeugt wurde, der von $M_z$ in $M_{xy}$ überginge, so daß der Impuls jetzt die Transformation $M_{xy}$ in $M_z$ bewirken wird. Fig. 17b und 17d zeigen die Profile, die auf diese Weise mit 90°-Gauß- und 90°-Sinc-förmigen Pulsen erhalten werden können. Dies ist zur Zeit die Methode der Wahl zur Erzeugung von befriedigenden Z-Magnetisierungs-Profilen in räumlichen Lokalisierungsexperimenten. Offensichtlich ist diese Prozedur nicht vollständig erwünscht, da sie notwendigerweise erfordert, daß die Magnetisierung mehr Zeit in der transversalen Ebene verbringt, wodurch die Empfindlichkeit des Experimentes reduziert wird, wenn die $T_2$- Relaxationszeiten kurz sind, was oftmals bei in-vivo-$^{31}$P-Spektroskopie oder bei Spektroskopie von festen Körpern wie Gummi oder Plastik der Fall ist. Genauer gesagt wird die gesamte Dauer der Impuls- und Gradientensequenz um ca. 55% verlängert, wenn Prä-Defokussierung entweder mit einem 90°-Gauß-Impuls oder mit einem 90°-Sinc-Impuls kombiniert wird.

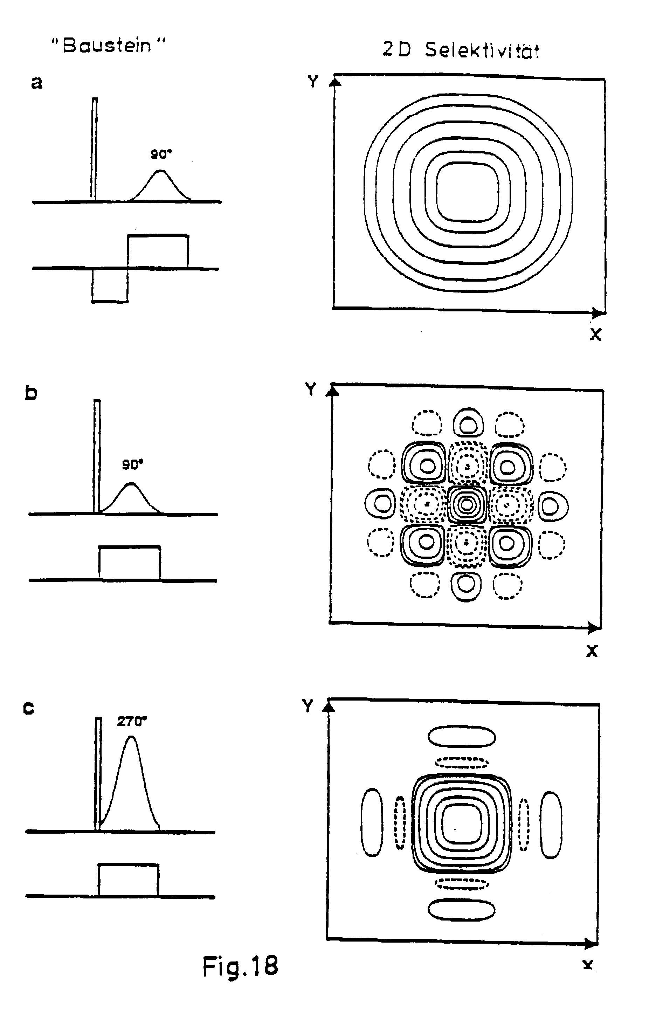

Im Zusammenhang mit Volumenlokalisierung ist es nützlich, sich bildlich vor Augen zu führen, in welcher Weise die eindimensionalen Profile von Fig. 17 (die zu ausgewählten Ebenen gehören) sich zusammenfügen, um das letztlich selektierte Volumen zu bilden. Fig. 18 zeigt die $M_z$-Profile, die längs der räumlichen Achsen X und Y erhalten werden, wenn zwei der "Bausteine", wie sie auf der linken Seite gezeigt sind, aufeinanderfolgend angelegt werden, wobei die Gradienten längs der X und Y-Richtungen (oder umgekehrt) gerichtet sind. In Fig. 18a ist das Profil gezeigt, das mit einem 90°-Gauß-Impuls mit Prä-Defokussierung zur transversalen Magnetisierung wie bei einem SPARS Experiment erhalten wird. Fig. 18b zeigt, wie der Versuch, den Prä-Defokussierungsschritt abzuschaffen, bewirkt, daß die resultierende $M_z$-Antwort bis zur Unkenntlichkeit verzerrt wird. Durch einfaches Vergrößern der HF-Amplitude zur Erzeugung eines 270°-Gauß-Impulses kann man jedoch die chaotische Antwort von Fig. 18b in die exzellente Verteilung von Fig. 18c aufgrund des Selbtrefokussierungseffektes eines 270°-Gauß-Impulses überführen. Die Konturlinien wurden bei ± 5, 10, 25, 50, 75 und 90% von $M^0$ aufgetragen. Insgesamt macht Fig. 18 deutlich, daß sämtliche störenden Abweichungen aufsummiert werden und man kann daher sehen, wie absolut notwendig die Refokussierung ist, um ein brauchbares VOI zu erhalten, wenn 90°-Impulse benutzt werden.

Fig. 17e zeigt das Profil eines 270°-Gauß-Impulses, der auf eine X-Magnetisierung gemäß dem Schema von Fig. 16a ohne Refokussierung und ohne prä-defokussierenden Schritt einwirkt. Alle Profile in Fig. 17 wurden durch Ermittlung der numerischen Lösungen der Bloch-Gleichungen für Impulse der gleichen Dauer und unter Annahme von instantaner Gradientenumschaltung berechnet. Die horizontale Achse ist in willkürlichen Einheiten skaliert, die, falls der Feldgradient linear ist, direkt proportional zum Abstand r vom Zentrum der Scheibe sind. Dadurch kann man das Verhalten der Magnetisierung unter zwei GaußImpulsen vergleichen, die sich nur dadurch unterscheiden, daß $\omega_1^{max}$ beim 270°-Impuls dreimal so groß ist, wie beim 90°-Impuls; beide Impulse haben dieselbe Gesamtdauer. Man beachte die größere Selektivität des 270°-Gauß-Impulses gegenüber dem refokussierten 90°-Gauß-Impuls, sowie die viel größere Selektivität dieser beiden Impulse gegenüber dem 90°-Sinc-Impuls. Man beachte außerdem, daß die HF-Peak-Amplitude des 270°-Gauß-Impulses nur 15% größer ist als der Peak des 90°-Sinc-Impulses.

Aus Fig. 17e kann ersehen werden, daß nur ungefähr 9% der Z-Magnetisierung, die durch einen selbstrefokussierenden 270°-Gauß-Impuls erzeugt wird, aufgrund von Signalauslöschung unbeobachtbar bleibt. Die Größe des beobachtbaren Signales und das resultierende Magnetisierungsprofil eines 270°-Gauß-Impulses reagieren sehr empfindlich auf das Abbruchsniveau der Gauß-Funktion. Die zeitartige Einhüllende ist gegeben durch

$$B_1(t) \;=\; B_1^{(max)}\exp[-a(t-\tfrac{1}{2}t_p)^2]\pi(0,t_p), \qquad [6]$$

wobei $\pi$ eine Kastenfunktion mit dem Wert 1 zwischen $t = 0$ und $t_p$ sowie dem Wert 0 überall sonst ist, und $a = (\ln2)/(t_{1/2})^2$, wobei $t_{1/2}$ die Halbwertsbreite der Gauß-Funktion ist. Der optimale Abbruch wird bei etwa $0{,}025\ B_1^{(max)}$ gefunden, weshalb alle 270°-Gauß-Impulse, die hier berücksichtigt wurden, bei 2,5% abgebrochen wurden.

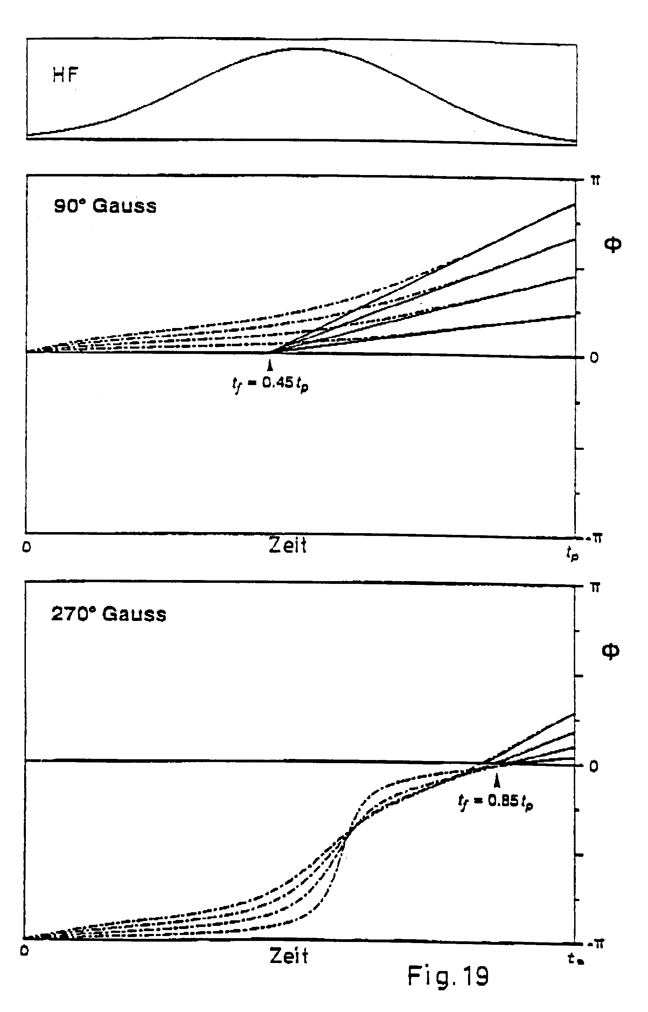

Das gewünschte Profil des 270°-Gauß-Impulses ist ein direktes Resultat seiner selbst-refokussierenden Eigenschaften kombiniert mit einer geeigneten Wahl des Abbruchsniveaus. Um das Prinzip zu verstehen, das hinter den 270°-Gauß-Impulsen steht, ist es nützlich, sich die Entwicklung der einzelnen Magnetisierungsvektoren während des Impulses vor Augen zu führen. Der Klarheit halber wird der Effekt von Pulsen betrachtet, die auf eine Gleichgewichts-Z-Magnetisierung einwirken. Der Selbst-Refokussierungseffekt von 270°-Gauß-Impulsen wurde unter Zuhilfenahme dar konventionellen "Grapefruit-Diagramme" weiter oben diskutiert, wo die Trajektorien auf der Einheitskugel gezeigt sind. An dieser Stelle betrachten wir jetzt die Entwicklung der Phase $\phi$ = arctan ($M_y/M_x$) einer Familie von Magnetisierungsvektoren bei unterschiedlichen Verschiebungen als Funktion der Zeit, wie für einen 90°-Gauß-Impuls in Fig. 19a gezeigt. Man beachte, daß die Trajektorien einen virtuellen Fokus bei etwa $t_f$ = 0,45 $t_p$ besitzen, wobei $t_p$ die Gesamtdauer des Impulses ist. Für einen gaußförmigen Impuls von derselben Gesamtdauer, aber mit einem Flippwinkel von 270° (d.h. mit einem dreifach größeren $\omega_1{}^{max}$) ist der Fokus der gleichen Magnetisierungsvektoren bei etwa 0,85 $t_p$, wie in Fig. 19b gezeigt. Es ist diese Verschiebung das Fokus der Magnetisierung, die verantwortlich ist für die erheblich reduzierte Phasendispersion, die am Ende eines selbstrefokussierenden 270°-Gauß-Impulses erhalten wird. Ein in dieser Hinsicht idealer Puls wäre ein solcher mit einem reellen Fokus bei $t_f \geq t_p$. Es ist nicht ratsam, den Impuls (oder besser den Gradienten) im Augenblick dar Fokussierung abzuschneiden, weil dabei das resultierende Magnatisierungsprofil stark gestört wird. Die horizontale Zeitachse in Fig. 19 erstreckt sich zwischen den Punkten, wo die Gauß-Funktionen abgebrochen sind. Die Vektoren befinden sich auf reduzierten Frequenzintervallen von 0,058 und beide Impulse haben einen 2,5%-Abbruch. Die Phasen (Auslenkung von der + x-Achse zur + y-Achse) starten bei $\phi$ = 0 für die 90°-Impulse und bei $\phi$ = -$\pi$, d.h. auf der -x-Achse, für die 270°-Impulse.

Die Selbstrefokussierung führt zu dem $M_z$-Profil von Fig. 17e für den 270°-Gauß-Impuls, der (ohne Gradientenumkehr!) die Kriterien für gute Selektivität erfüllt, dadurch, daß er eine fast flache Region nahe der Resonanz mit den steil abfallenden Flanken und lediglich geringer Welligkeit weit entfernt von der Resonanz besitzt. Die Scheibendicke wie in Fig. 17e gezeigt und als reduzierte Frequenz ausgedrückt ist $\overline{o}r$ = 0,65. Ein Blick auf die Konturzeichnung der zweidimensionalen Selektivität das 270°-Gauß-Impulses in Fig. 18c zeigt, daß das VOI sehr gut definiert und beinahe quadratisch ist.

Einer der Hauptnachteile der VSE (Volume Selective Excitation) Technik ist, daß ihr $M_z$-Profil nicht die wünschenswerte kastenähnliche Form besitzt, so daß man Durchbrüche von Regionen außerhalb des VOI gewärtigen muß. Unsere Simulationen zeigen, daß in dem Fall, wo die Spindichte des Untersuchungsobjektes (oder die Dichte eines bestimmten Spintyps im Objekt) durch ein Kontinuum repräsentiert wird, der Beitrag zum Signal von außerhalb des VOI (das durch die Scheibendicke $\overline{o}r$ definiert ist; siehe Fig. 17e) nach einem selbstrefokussierenden 270°-Gauß-Impuls von ungefähr 0,02 % des totalen Signales von dem dreidimensionalen Objekt beträgt. Interessanterweise kommen über 90% dieses vernachlässigbar kleinen Durchbruchsignales aus einem Abstand von weniger als $\overline{o}r$ um das VOI. Aus diesem Grund ist es auf jeden Fall im Zusammenhang mit volumenselektiver Spektrospie kaum lohnend, nach Impulsformen zu suchen, die besser als die gaußförmigen sind.

Auf den ersten Blick könnte man glauben, daß ein größeres Hindernis zur Einführung von selbstrefokussierenden 270°-Gauß-Impulsen darin besteht, daß die Gradienten nicht instantan ein- und ausgeschaltet werden können. Wenn man die konventionelle Sequenz zur Konvertierung $M_x$ in $M_z$ (Fig. 16c) betrachtet, bemerkt man, daß ein bestimmter Freiheitsgrad darin besteht, die Länge der prä-defokussierenden Verzögerung "abzuzwicken" um die endlichen Gradientenschaltzeiten zu kompensieren. Im Gegensatz dazu hat ein selbst-refokussierender 270°-Impuls kombiniert mit dem Gradientenszenario von Fig. 16a diesen Freiheitsgrad nicht. Wenn wir annehmen, daß die Magnetisierung exakt längs der X-Achse ausgerichtet ist, bevor der Gradient und der HF-Impuls aktiviert werden, bauen sich in der Tat beträchtliche Phasenfehler in dem Zeitintervall $t_g$ auf, wenn der Gradient graduell angeschaltet wird, und verursachen somit Verzerrungen im resultierenden Profil. So gesehen wären die Simulationen der Profile, die für Fig. 17e und 18c berechnet wurden, nichts als "Seifenblasen", da sie durch die Annahme einer instantanen Gradientenschaltung die Effekte dieser Verzögerung nicht berücksichtigen.

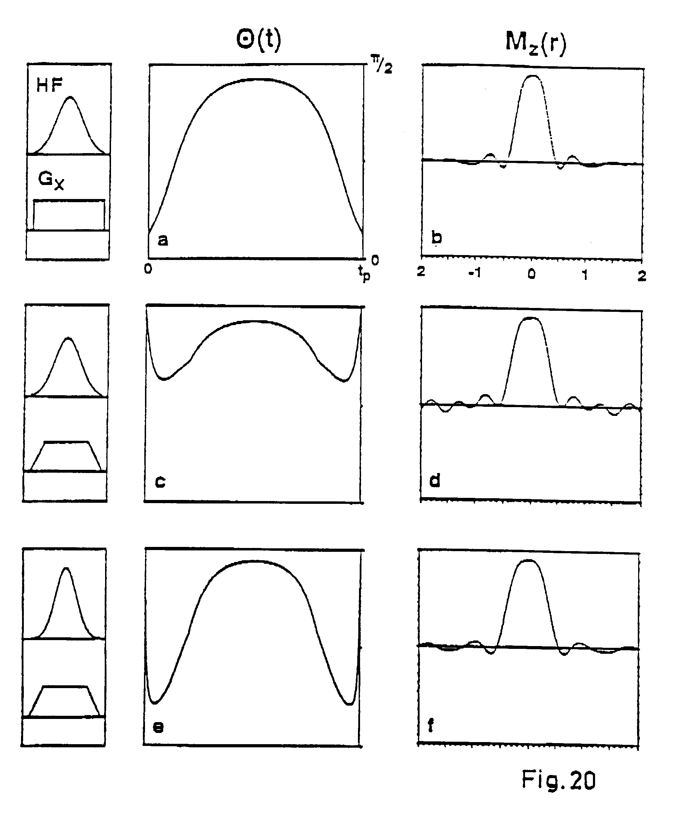

Die Situation kann jedoch verbessert werden, wenn die Schaltzeiten in die Dauer $t_p$ eines HF-Impulses nach Art von Fig. 16d integriert werden. Es ist realistisch anzunehmen, daß die Schaltverzögerungszeit $t_g$ bis zu 20% der HF-Impulslänge $t_p$ (sowohl zu Beginn als auch zum Ende des Impulses) betragen kann. Fig. 20b zeigt dasselbe $M_z$-Profil wie in Fig. 17e, das mit dem gleichen 270°-Gauß-Impuls und wieder unter Annahme instantaner Gradientenschaltung erhalten wurde. Fig. 20d zeigt, wie das Profil verzerrt wird, wenn man denselben HF-Impuls benutzt, aber einen Feldgradienten, der linear von t = 0 bis t = 0,2 $t_p$ ansteigt und ähnlich linear von t = 0,8 $t_p$ bis t = 1,0 $t_p$ abfällt.

Es ist klar, daß diese Verzerrungen ernstlich sind und es notwendig ist, einen Weg zur Kompensation dieser Effekte zu weisen.

Zu diesem Zweck betrachten wir die Konsequenzen einer Gradientenschaltung während des Impulses auf die Zeitabhängigkeit des instantanen Kippwinkels Θ. Eine der intrinsischen Eigenschaften eines Gauß-Impulses in Anwesenheit eines konstanten Feldes (d.h. in Abwesenheit einer Gradientenschaltung) besteht darin, daß das effektive Feld während eines frühen Abschnittes des Impulses nahe zur Z-Achse ausgerichtet ist, sich graduell zur Transversalebene bewegt, während $B_1$ ansteigt und sich dann während des letzten Impulsabschnittes zurück zur Z-Achse bewegt. Dies führt zu sogenannten "Tränentropfen"-Trajektorien für Magnetisierungsvektoren mit großer Verschiebung. Das Verhalten des Kippwinkels Θ(t) (Auslenkung bezüglich der Z-Achse) ist in Fig. 20a für einen 270°-Gauß-Impuls in Anwesenheit eines konstanten Feldes aufgezeichnet. Das Ergebnis ist das unverzerrte Profil von Fig. 20b. Wenn man jetzt das Verhalten von Θ(t) für einen Impuls betrachtet, bei dem der Gradient langsam ansteigt, erkennt man, daß gleich zu Beginn des HF-Impulses in grellem Kontrast zur vorherigen Situation keine Z-Komponente des effektiven Feldes, sondern ein nicht verschwindendes $B_1$ vorhanden ist. Deswegen gilt $\Theta(t=0) = \pi/2$. Fig. 20c verdeutlicht, wie das Verhalten von Θ(t) während der Gradientenschaltperiode verzerrt wird. Es ist klar, daß dies in einer beträchtlichen Verzerrung der Trajektorien resultiert, so daß das unbrauchbare Profil von Fig. 20d nicht überrascht.

Um den Effekt der Gradientenschaltung auf das Anregungsprofil zu eliminieren ist es notwendig, das Verhalten von Θ(t) mit $t_g$ = 0 während einer Sequenz soweit wie möglich an das Verhalten des idealisierten Falles von Fig. 20a anzupassen. Die offensichtlichste Methode wäre einfach die Gewichtung der Pulsform mit dem Profil des Gradienten, da Θ konstant bleibt, wenn eine Reduktion der Gradientenamplitude begleitet ist von einer entsprechenden Reduktion der HF-Amplitude. Dies würde jedoch eine Verzerrung der Trajektorien aufgrund der folgenden Reduktion der Größe des effektiven Feldes während der Gradientenanstiegsperiode übriglassen. Ein befriedigenderer Ansatz besteht darin, die gaußförmige Einhüllende mit der Gradienteneinhüllenden zu modifizieren und eine Zeitspanne für eine größere Rotation zum Beginn und zum Ende des Impulses, wenn die HF-Amplitude niedrig ist, zuzulassen. Dies kann ganz einfach durch die Reduzierung des Abbruchs der Gaußfunktion erreicht werden.

Fig. 20e zeigt Θ(t) für einen 270°-Gauß-Impuls mit einem Abbruch bei 0,28% (im Gegensatz zu 2,5% in Fig. 20c), und man sieht ein Verhalten, das dem idealen von Fig. 20a sehr ähnlich ist mit Ausnahme der Tatsache, daß Θ gegen $\pi/2$ ganz zu Beginn und ganz zum Ende des Pulses strebt. Diese geringe Abweichung ist nicht wichtig, da das effektive Feld an diesen Punkten so niedrig ist, daß es wenig Einfluß besitzt, und tatsächlich kann man sehen, daß das Profil von Fig. 20f exakt dasselbe ist wie das von Fig. 20b, mit Ausnahme einer trivialen Skalierung der Scheibendicke, die von einer leicht höheren Leistung verursacht wird, wie sie für einen Puls mit niedrigerem Abbruchsniveau erforderlich ist. Der Skalierungsfaktor ist ungefähr 1,2 für den Fall, wo $t_g/t_p$ = 0,2. So ist es durch einfache Reduzierung des Abbruchniveaus für einen selbstrefokussierenden 270°-Gauß-Impuls möglich, nahezu vollständig die Effekte der Gradientenschaltung zu kompensieren.

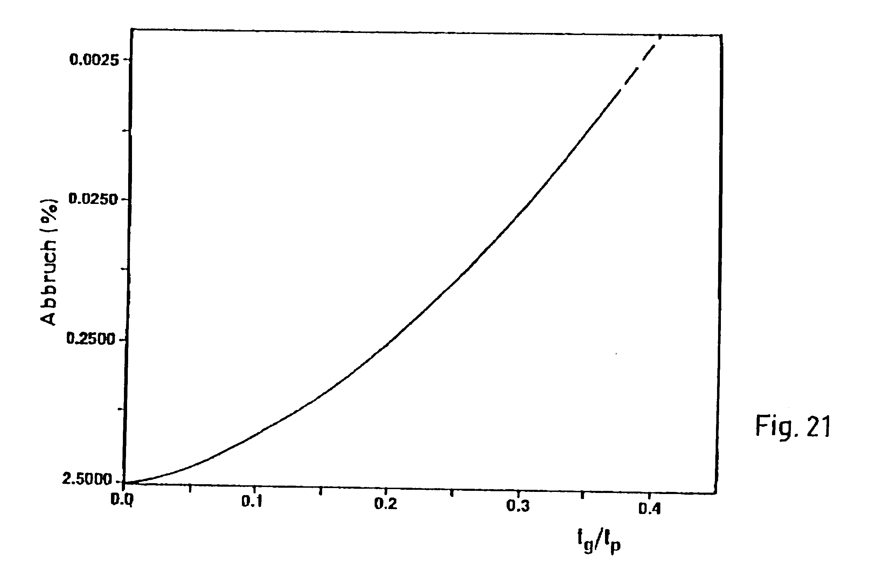

Die Simulationen von Fig. 20c bis Fig. 20f wurden alle für eine Situation ausgeführt, wo die Gradientenschaltzeit $t_g$ = 0,2 $t_p$. Fig. 21 zeigt das Abbruchsniveau, das nötig ist, um das gleiche Profil wie in Fig. 20b für einen Bereich von Schaltzeiten $t_g/t_p$ zu erhalten. Bei Werten von $t_g/t_p$ > 0,35 ist es leider unmöglich, ein befriedigendes Profil lediglich durch Reduzierung des Abbruchniveaus zu gewinnen.

Aus der obigen Diskussion wird klar, daß 270°- Gauß-Impulse ohne Refokussierung ein VOI haben, das mindestens genauso gut definiert ist wie das von einem 90°-Gauß-Impuls mit Refokussierung. Außerdem sind Sequenzen, bei denen 270°-Gauß-Impulse benutzt werden, signifikant weniger empfindlich gegen Fluß- oder $T_2$-Relaxations-Effekte. In SPARS oder SPACE (Spatial and Chemical Shift encoded Excitation) Experimenten schlagen wir die Benutzung von selbstrefokussierenden 270°-Gauß-Impulsen anstelle der selektiven 90°-Impulsen vor.

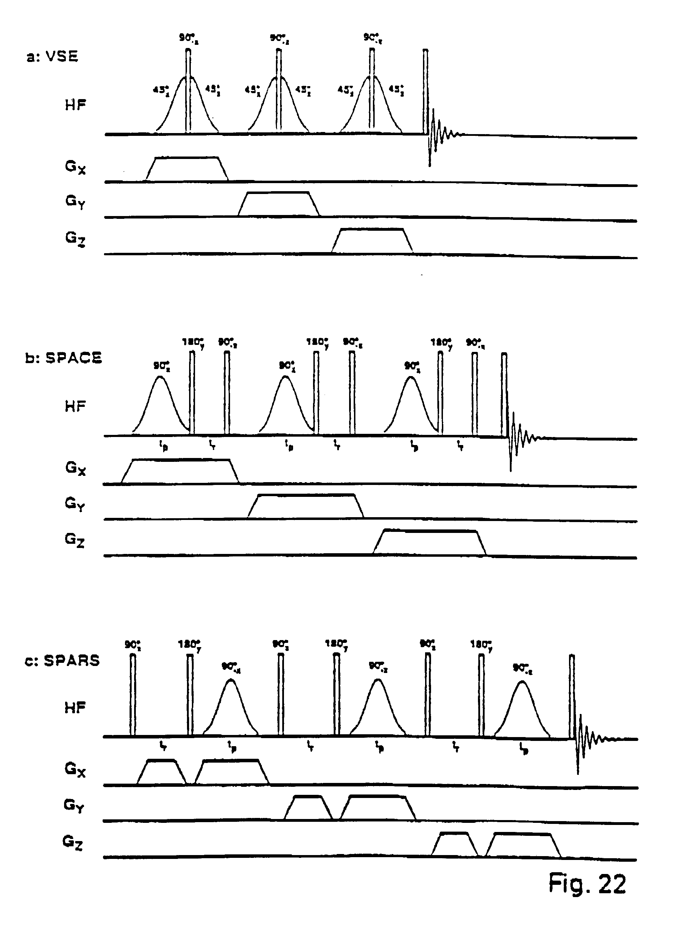

Die Figuren 22a bis 22c zeigen Impuls- und Feldgradientenschemata für (a) VSE, (b) SPACE und (c) SPARS Experimente. Die großbuchstabigen Subskripte X, Y und Z beziehen sich auf orthogonale räumliche Richtungen in der Probe, während die kleinbuchstabigen Subskripte x und y die Phasen der HF-Impulse im rotierenden Koordinatensystem bezeichnen. Wenn selektive 90°-Gauß-Impulse der Dauer $t_p$ mit 2,5 %-Abbruch benutzt werden (oder falls 90°-sinc-Impulse der Dauer $t_p$ mit drei Null-Durchquerungen statt dessen benutzt werden), dann gilt in Fig. 22b und Fig. 22c $t_r \approx 0,55\ t_p$. In diesen Schemata wird angenommen, daß die Gradientenimpulse vor Beginn der HF-Impulse angeschaltet und nach Ende der HF-Impulse abgeschaltet werden. Der letzte Impuls in den Sequenzen kann einfach ein 90°-Leseimpuls sein, der durch irgendeine Kombination von Pulsen zur Lösungsmittelunterdrückung, Editierung von Spektren u.s.w. eingeleitet werden kann.

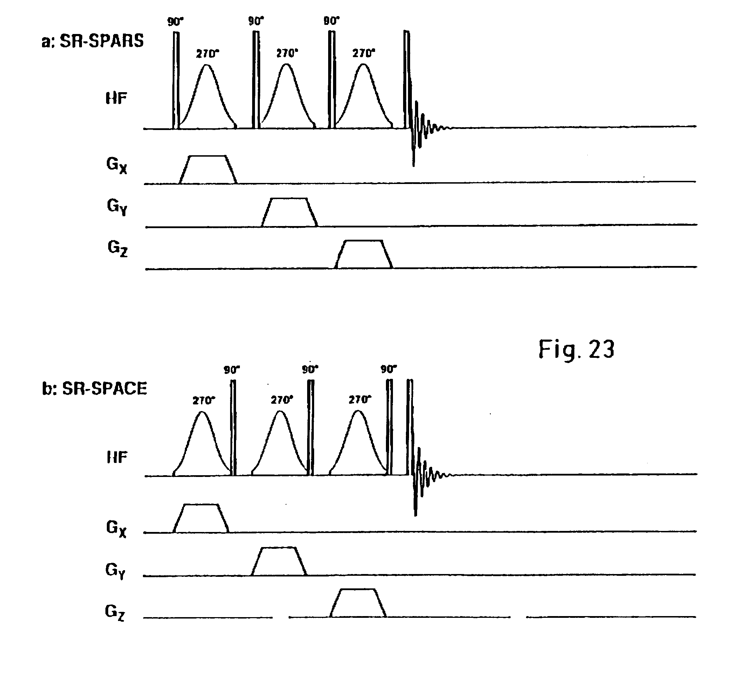

Im SPARS-Experiment von Fig. 22c wird die Notwendigkeit für den prä-defokussierenden Gradienten und den nicht-selektiven 180°-Impuls deutlich. Bei Einsatz der erfindungsgemäßen 270°-Gauß-Impulse vereinfacht sich die Sequenz zu der selbstrefokussierenden SPARS-Sequenz (SR-SPARS) von Fig. 23a.

Ähnlich kann in dem SPACE-Experiment von Fig. 22b auf den refokussierenden Gradienten und den nicht-selektiven 180°-Impuls (der ein sehr aufwendiges Merkmal des Experiments ist) verzichtet werden, und die Sequenz wird zu der (selbstrefokussierenden) SR-SPACE-Sequenz gemäß Fig. 23b. Wie bei den Originalversionen dieser Experimente sind die beiden neuen Sequenzen formal äquivalent. In der Tat ist es eine Geschmacksfrage, ob der nicht-selektive Impuls vor oder nach dem selektiven Impuls plaziert wird. Wir vermuten, daß es vorzuziehen ist, ihn vor den selektiven Impuls wie in Fig. 23a zu setzen, da dies der transversalen Magnetisierung mehr Zeit zum Dephasieren gibt. Diese Modifikationen sollten sowohl das $z$-Magnetisierungs-Profil verbessern als auch die Empfindlichkeit durch Reduzierung der Aufenthaltszeit in der transversalen Ebene erhöhen.

Falls selbst-refokussierende 270°-Gauß-Impulse benutzt werden, um $M_z$ in $M_{xy}$ zu konvertieren, gibt es eine kleine $M_y$-Komponente, die antisymmetrisch in Bezug auf die Verschiebung ist, was die Scheibenselektion bei inhomogenen Objekten stören kann. Das SR-SPACE-Experiment wird von diesem Problem nicht berührt, weil in jeder Stufe des Experimentes die unerwünschten Komponenten durch Dephasierung unbeobachtbar bleiben. Auf diese Weise werden die unerwünschten Rest-$M_y$-Komponenten vollständig aus den Experimenten herausgefiltert.

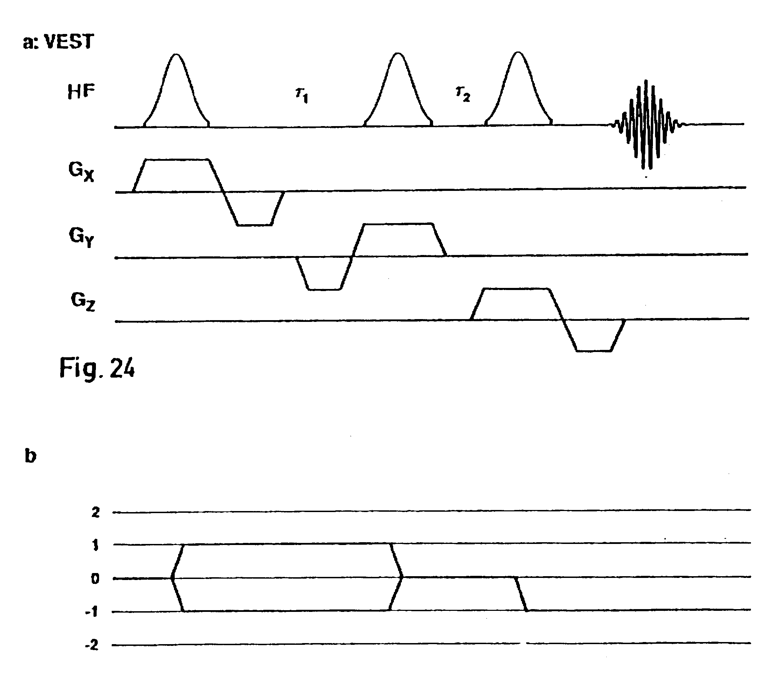

In der ursprünglichen VEST-Sequenz von Fig. 24 muß die Zeitverzögerung $\tau_1$ mindestens so lang sein, wie die Zeit, die notwendig ist zum Schalten der Gradientenimpulse. Während dieser Zeitspanne ist die relevante Magnetisierung in der transversalen Ebene. Bei der SR-VEST-Methode nach Fig. 25a, wo 270°-Gauß-Impulse die üblichen 90°-Impulse ersetzen, besteht weder Notwendigkeit für refokussierende noch für prädefokussierende Gradientenimpulse, so daß $\tau_1$ im wesentlichen 0 sein kann, was die Sequenz größtenteils unempfindlich für $T_2$ macht. Während der $\tau_2$-Verzögerung wird die selektierte Magnetisierung längs der Z-Achse ausgerichtet Da diese Verzögerung im SR-Experiment ebenfalls 0 sein kann, ist die Sequenz auch weitgehend unempfindlich gegen $T_1$ . Man beachte außerdem, daß der technische Aufwand für das Experiment jetzt reduziert ist.

Der Preis für diese Vorteile besteht darin, daß es nötig werden kann, ausgefeiltere Phasenzyklen zu benutzen. Um eine gute Lokalisierung beim SR-VEST-Experiment zu erhalten, ist der erste Impuls in fester Phasenbeziehung zu dem Empfänger geschaltet, um die Unterdrückung des freien Induktionszerfalls nach dem dritten Impuls sicherzustellen. Um andere Pfade als den, der zum stimulierten Echo führt (siehe die Kohärenz-Transfer-Pfade von Fig. 24b), gut zu unterdrücken, kann man auch ein $\tau_2$-Intervall zwischen dem zweiten und dem dritten Impuls ohne Signalverluste durch $T_2$-Relaxation einfügen und die $G_Y$- und $G_Z$-Gradienten in dieses $\tau_2$-Intervall ausdehnen, um unerwünschte Kohärenzen zu dephasieren. Alternativ kann man einen 4-Schritt-Phasen-Zyklus einsetzen.

Interessant sind die Ähnlichkeiten zwischen der SR-SPARS-Sequenz und der SR-VEST-Sequenz von Fig. 23a und 25. In ihren Auswirkungen unterscheiden sich die beiden Sequenzen lediglich in der trivialen Frage, wo die selektierte Magnetisierung zwischen den "Bausteinen" der Sequenz gespeichert wird. In der SR-SPARS-Sequenz wird die Magnetisierung immer längs der Z-Achse des rotierenden Koordinatensys-stems gespeichert, während in der SR-VEST-Sequenz die Magnetisierung längs den -x, -z und +x-Achsen gespeichert wird.

Bei weiterer Betrachtung zeigt sich, daß die harten 90°-Impulse, die bei SR-SPARS oder SR-SPACE benutzt werden, um die Magnetisierung auf die z-Achse zurückzubringen, eine Minimierung der Empfindlichkeit des Experimentes gegen HF-Inhomogenitäten erlauben. In der Literatur (siehe L. Emsley and G. Bodenhausen, Magn. Reson. in Med. 10,273-281 (1989), speziell Seite 279 und Fig. 5f) wurde gezeigt, daß die Form des Magnetisierungsprofiles, wie es von 270°-Gauß-Impulsen erzeugt wird, ziemlich unempfindlich gegen HF-Inhomogenität ist. Wenn jedoch die Sequenzen von Fig. 23 oder Fig. 25 blindlings mit lauter HF-Impulsen der gleichen Phase eingesetzt würden, wären die totalen Flippwinkel, die die Magnetisierung im VOI erfährt, 1170° bzw. 810°, und die Effekte der HF-Inhomogenität wären kumulativ. Wenn jedoch die SR-VEST-Sequenz so modifiziert wird, daß die Phasen der drei Pulse in Fig. 25 ± y, + y und -y sind, wird der totale Flippwinkel auf ein akzeptables Maß von ± 270° reduziert. Diese Vorschrift ist kompatibel mit dem Phasenzyklus, der zur Unterdrückung des auf den letzten Impuls folgenden freien Induktionszerfalles erforderlich ist, sie ist jedoch inkompatibel mit den vollen Phasenzyklus-Erfordernissen für die eindeutige Selektion der Kohärenz-Transfer-Pfade, und in dem Falle, wo HF-Inhomogenität ein Problem ist, muß die Unterdrückung von anderen Pfaden durch Anlegen von Gradienten im $\tau_2$-Intervall erreicht werden.

In der SR-SPARS-Sequenz, wo jeder Baustein der Sequenz zwei Impulse enthält, schlagen wir die Benutzung folgender Phasen vor:

$$90°_{+y} \, 270°_{-y} \qquad 90°_{-y} \, 270°_{+y} \qquad 90°_{+y} \, 270°_{-y} \qquad 90°_{+y} \, .$$

Auf diese Weise wird der totale Flippwinkel auf 90° reduziert, und da es bei SR-SPARS keine Phasenzyklus-Erfordernisse gibt, sollte kein Hindernis der Einführung dieser Phase entgegenstehen. Daher ist die SR-SPARS-Sequenz mit 270°-Impulsen nicht empfindlicher gegen HF-Inhomogenitäten als eine normale Sequenz mit 90°-Impulsen, vorausgesetzt, Diffusionseffekte können vernachlässigt werden.

Es ist möglich, die Effekte der Relaxation auf die ursprünglichen Sequenzen in Fig. 22 und Fig. 24 sowie die selbst-refokussierenden Sequenzen in Fig. 23 und Fig. 25 durch Einfügen einer einfachen mono-exponentiellen $T_2$-Dämpfung in den Simulationen der Bloch-Gleichungen zu quantifizieren. Dabei vernachlässigen wir den Effekt der Longitudinalen $T_1$-Relaxation.

Unsere Simulationen zeigen, daß die Signalintensität, falls die Sequenz mit Gradientenumkehr gemäß Fig. 16b bei einem System mit einer $T_2$-Relaxationszeit verwendet wird, die gleich der Länge $t_p$ des (abgebrochenen) 90°-Gauß-Impulses ist, auf nur 30% geschwächt wird. Im Gegensatz dazu bleibt bei Verwendung der Sequenz gemäß Fig. 16a und der Annahme von instantaner Gradientenschaltung bei der gleichen Relaxationszeit und einem selbst-refokussierenden 270°-Impuls immerhin 60% des Signales übrig. Die Elimination des Gradientenumkehrschrittes ergibt also eine Verbesserung der Empfindlichkeit um einen Faktor 2. Ein nützlicher Weg zur Quantifizierung der Effekte der transversalen Relaxation auf verschiedene Pulssequenzen ist die Aufzeichnung der Signalintensität als Funktion des dimensionslosen Verhältnisses $t_p/T_2$ (siehe Fig. 26). Durch Einfügen von $t_p$ in den Zähler werden einfach die resultierenden Kurven (in erster Ordnung) in Bezug auf die Selektivität normiert. Obwohl eine mono-exponentielle Dämpfung in die Bloch-Gleichungen eingefügt wurde, ist der Zerfall des Signales allgemein multi-exponentiell. Da angenommen wird, daß nur die transversale Komponente der Magnetisierung zerfällt, und da diese Komponente ein kontinuierlich variierender Bruchteil des Gesamtvektors darstellt, wird jeder Vektor während des Impulses multi-exponentiell relaxieren. Auch wird für eine gegebene Impulslänge jede Verschiebung eine unterschiedliche Trajektorie durch den Spinraum besitzen, weshalb jede Verschiebung in geringfügig unterschiedlicher Weise im Vergleich zu den anderen relaxieren wird, was zu einer Verzerrung des resultierenden Magnetisierungsprofiles aufgrund von transversaler Relaxation führt. Glücklicherweise ist für einen 270°-Gauß-Impuls diese Verzerrung vernachlässigbar klein.

Fig. 26a zeigt einen 90°-Gauß-Impuls mit dem Szenario von Fig. 18a (strichpunktierte Linie) und einen 270°-Gauß-Impuls mit dem selbst-refokussierenden Szenario von Fig. 18c (kurzgestrichelt). Die dimensionslosen Zerfallskonstanten ("Relaxationskoeffizienten") dieser Kurven sind unter Berücksichtigung dreidimensionaler Volumenselektion 3 k = 3,3 bzw. 1,3. Fig. 26b zeigt die Abschwächung verschiedener Magnetisierungsvektoren bei unterschiedlichen Verschiebungen im Szenario von Fig. 18c als Funktion von $t_p/T_2$. Die Vektoren haben reduzierte Verschiebungen von 0, 0.15, 0.23, 0.35, 0.40 und 0.42.

Die Relaxation führt auch zu einer Verzerrung der Magnetisierungstrajektorien, die von $t_p/T_2$ abhängt, so daß jede Verschiebung auch einen multi-exponentiellen Zerfall als Funktion des Verhältnisses $t_p/T_2$ erfährt, wie in Fig. 26b gezeigt. Zum Glück sieht man aus Fig. 26a, daß die Abschwächung des Signales der Gauß-Impulse, die gemäß den Schemata von Fig. 16 angelegt wurden, nahezu mono-exponentiell verläuft. Dies legt nahe, daß der Zerfall bei einem gegebenen Experiment ungefähr beschrieben werden kann durch

$$(S/S_0)_i \approx \exp\{-k_i t_p/T_2\}. \qquad [7]$$

Die dimensionslose Zerfallskonstante $k_i$, die wir "Relaxationskoeffizient" nennen, dient als ein gutes Maß für die Empfindlichkeit einer Sequenz auf transversale Relaxation. In der Tat kann eine physikalische Interpretation darin gesehen werden, daß ein Wert von $k_i = 1$ anzeigt, daß die Magnetisierung im gleichen Umfang geschwächt wird, als wenn sie für die Zeitdauer $t_p$ lediglich in der transversalen Ebene verharren würde. Je kleiner der Wert von k, umso weniger empfindlich ist die Sequenz gegen Relaxation und umso größer ist ihre Leistungsfähigkeit. Die Relaxationskoeffizienten nach Fig. 26a sind $k_i = 1,1$ für Sequenzen mit einem 90°-Gauß-Impuls gemäß Fig. 16b oder 16c und $k_i = 0,43$ für Sequenzen mit einem 270°-Gauß-Impuls gemäß Fig. 16a oder 16d.

Es ist ganz einfach, diese Analyse auf dreidimensionale lokalisierte Spektroskopiesequenzen, wie sie oben erwähnt wurden, zu erweitern, da alle diese Sequenzen im wesentlichen aus drei aufeinanderfolgenden Bausteinen mit in drei orthogonalen Richtungen angelegten Gradienten stehen. Deshalb gilt

$$(S/S_0)_{3i} \approx \exp\{-3k_i t_p/T_2\}, \qquad [8]$$

und die Relaxationskoeffizienten der drei-dimensionalen Experimente sind ganz einfach diejenigen für die ein-dimensionalen Bausteine, d.h. $3k_i = 3,3$ für die normalen SPARS-und VEST-Sequenzen, und $3k_i = 1,3$ für die zugehörigen SR-Sequenzen. Dies zeigt deutlich, wieviel weniger empfindlich gegen Relaxation die selbstrefokussierenden Sequenzen im Vergleichen zu den mit Hilfe von Gradienten refokussierten Äquivalenten sind. In der Tat ist eine ganze drei-dimensionale SR-Sequenz lediglich 15% empfindlicher gegen transversale Relaxation als ein einzelner scheibenselektiver 90°-Impuls gemäß Fig. 16b oder Fig. 16c.

Wir haben nicht explizit den Relaxationseffekt auf die stimulierten Echo-Sequenzen mit $\tau_1$-Verzögerungen berücksichtigt, die länger sind als die zur Gradientenschaltung erforderliche Zeit, aber es ist klar, daß mit wachsendem $\tau_1$ einfach die Empfindlichkeit gegen Relaxation ansteigt, was durch Modifizierung von Gl.-[8] beschrieben werden kann:

$$(S/S_0)_{3i} \approx \exp\{(-3k_i t_p + 2\tau_e)/T_2\} \qquad [9]$$

Dabei ist $\tau_e = \tau_1 - 2t_r$ und der Faktor 2 in Gl.[9] wird zur Berücksichtigung der Tatsache eingeführt, daß die Magnetisierung in der Transversalebene während zweier $\tau_e$-Verzögerungen verharrt. Eine Ausdehnung der Länge der $\tau_2$-Verzögerungen hat keinen Effekt auf die Empfindlichkeit, solange die longitudinale Relaxation vernachlässigt wird.

Aus dem vorstehenden ergibt sich, daß nach der Erfindung überall da, wo bisher selektive 90°-Impulse, ggf. in Verbindung mit Maßnahmen zur Refokussierung der durch den 90°-Impuls dephasierten transversalen Magnetisierung, eingesetzt worden sind, ein 270°-Gaußimpuls eingesetzt werden kann, durch den Rephasierungs-Maßnahmen experimenteller oder auch rechnerischer Natur entbehrlich werden.

## Patentansprüche

1. Verfahren zum frequenzselektiven Anregen von NMR-Signalen mit selbständiger Refokussierung der Phasendispersion der durch die Anregung erzeugten transversalen Magnetisierung, bei welchem die Anregung durch Einstrahlen einer HF-Impulsfolge auf eine sich in einem homogenen statischen Magnetfeld befindende Probe erfolgt, welche HF-Impulsfolge wenigstens einen frequenzselektiven 270°-Impuls umfaßt, dadurch gekennzeichnet, daß der wenigstens eine 270°-Impuls ein frequenzselektiver 270°-Gaußimpuls ist.

2. Verfahren nach Anspruch 1 unter Verwendung einer NOESY-Impulsfolge, dadurch gekennzeichnet, daß wenigstens einer der in der NOESY-Impulsfolge enthaltenen frequenzselektiven Anregungsimpulse ein 270°-Gaußimpuls ist.

3. Verfahren nach Anspruch 1 unter Verwendung einer bilderzeugenden Impulsfolge bei der NMR-Tomographie, dadurch gekennzeichnet, daß wenigstens einer der in der bilderzeugenden Impulsfolge enthaltenen frequenzselektiven Anregungsimpulse ein 270°-Gaußimpuls ist.

4. Verfahren nach Anspruch 1 unter Verwendung einer eine Volumenselektion bewirkenden Impulsfolge für die volumenselektive NMR-Spektroskopie, dadurch gekennzeichnet, daß wenigstens einer der in der volumenselektiven Impulsfolge enthaltenen frequenzselektiven Anregungsimpulse ein 270°-Gaußimpuls ist.

## Claims

1. A method of frequency-selective excitation of NMR signals with independent refocussing of the phase dispersion of the transverse magnetization generated by the excitation, wherein the excitation occurs by irradiating upon a sample, which is located within a homogeneous static magnetic field, an rf pulse sequence comprising at least one frequency-selective 270° pulse, characterized in that the at least one 270° pulse is a frequency-selective 270° Gaussian pulse.

2. A method according to claim 1 using a NOESY pulse sequence, characterized in that at least one of the frequency-selective excitation pulses comprised in the NOESY pulse sequence is a 270° Gaussian pulse.

3. A method according to claim 1 employed in NMR tomography, using an image-generating pulse sequence, characterized in that at least one of the frequency-selective excitation pulses comprised in the image-generating pulse sequence is a 270° Gaussian pulse.

4. A method according to claim 1 for volume-selective NMR spectroscopy, using a pulse sequence effecting a volume selection, characterized in that at least one of the frequency-selective excitation pulses comprised in the volume-selective pulse sequence is a 270° Gaussian pulse.

**Revendications**

1. Procédé d'excitation sélective en fréquence de signaux RMN avec refocalisation spontanée de la dispersion de phase de l'aimantation transversale produite par l'excitation, selon lequel l'excitation s'effectue en émettant une série d'impulsions H.F. sur un échantillon se trouvant dans un champ magnétique statique homogène, ladite série d'impulsions H.F. comprenant au moins une impulsion de 270° sélective en fréquence,
**caractérisé** en ce que ladite au moins une impulsion de 270° est une impulsion de Gauss de 270° sélective en fréquence.

2. Procédé selon la revendication 1 en utilisant une série d'impulsions NOESY, **caractérisé** en ce qu'au moins une des impulsions d'excitation sélectives en fréquence contenues dans la série d'impulsions NOESY est une impulsion de Gauss de 270°.

3. Procédé selon la revendication 1 en utilisant une série d'impulsions génératrice d'image pour la tomographie RMN, **caractérisé** en ce qu'au moins une des impulsions d'excitation sélectives en fréquence contenues dans la série d'impulsions génératrice d'image est une impulsion de Gauss de 270°.

4. Procédé selon la revendication 1 en utilisant une série d'impulsions produisant une sélection de volume pour la spectroscopie RMN sélective en volume, **caractérisé** en ce qu'au moins une des impulsions d'excitation sélectives en fréquence contenues dans la série d'impulsions sélective en volume est une impulsion de Gauss de 270°.

Fig.1

Fig. 2

Fig. 3

Fig. 4

Fig. 5

Fig. 6

$M_{xy}$

Reduzierte Verschiebung    Fig. 7

Φ

90%

Reduzierte Verschiebung    Fig. 8

Fig. 9

Fig.10

Fig:11

Fig.12

Fig. 15

Fig. 14

Fig. 13

HF

Gradient

a.

$t_g$    $t_p$    $t_g$

b.

c.

d.

EP 0 396 710 B1

Fig. 16

GRADIENT

IMPULS

Fig.17

"Baustein"

2D Selektivität

Fig.18

Fig. 19

Θ(t)

M_z(r)

Fig. 20

Fig. 21

Fig. 22

a: SR-SPARS

b: SR-SPACE

Fig. 23

EP 0 396 710 B1

a: VEST

HF

$T_1$          $T_2$

$G_X$

$G_Y$

$G_Z$

Fig. 24

b

2

1

0

-1

-2

Fig. 25

SR-VEST

HF

270°  270°  270°

$G_X$

$G_Y$

$G_Z$

EP 0 396 710 B1

Fig. 26